# EUROPEAN PATENT APPLICATION

(11) **EP 4 340 566 A1**
(43) Date of publication of application: **20.03.2024**
(21) Application number: 21951388.4
(22) Date of filing: 30.07.2021
(51) Int. Cl.: H10K 50/00, H10K 59/00

(54) **LIGHT-EMITTING SUBSTRATE AND MANUFACTURING METHOD THEREFOR, BACKLIGHT SOURCE AND DISPLAY APPARATUS**

(71) Applicant: BOE Technology Group Co., Ltd., Chaoyang District, Beijing 100015 (CN); Hefei Xinsheng Optoelectronics Technology Co., Ltd., Xinzhan Industrial Park Hefei Anhui 230012 (CN)
(72) Inventor: LIU, Chunjian, Beijing 100176 (CN); HAO, Wei, Beijing 100176 (CN); XU, Zouming, Beijing 100176 (CN); TIAN, Jian, Beijing 100176 (CN); WU, Xintao, Beijing 100176 (CN); LEI, Jie, Beijing 100176 (CN); WANG, Jie, Beijing 100176 (CN); ZHANG, Jianying, Beijing 100176 (CN); FAN, Wenjin, Beijing 100176 (CN); XU, Jiawei, Beijing 100176 (CN); LI, Le, Beijing 100176 (CN); ZHANG, Jian, Beijing 100176 (CN)
(74) Representative: Studio Torta S.p.A.
(86) International application number: PCT/CN2021/109837
(87) International publication number: WO 2023/004798

(57) **Abstract**

The present disclosure provides a light-emitting substrate and a manufacturing method thereof, a backlight and a display device. The light-emitting substrate includes: a substrate including a plurality of light-emitting regions arranged in an array, each of the plurality of light-emitting regions including a driving circuit and at least one light-emitting unit connected to the driving circuit; a first electrically conductive portion on the substrate and connected to the driving circuit and the at least one light-emitting unit in each light-emitting region; and a second electrically conductive portion on the substrate and including a plurality of pads. The first electrically conductive portion and the second electrically conductive portion are on a same layer.

## Description

### TECHNICAL FIELD

The present disclosure relates to the field of optical technology, and in particular, to a light-emitting substrate and a manufacturing method thereof, a backlight comprising the light-emitting substrate, and a display device comprising the light-emitting substrate.

### BACKGROUND

With the continuous development of display technology, users have put forward higher and higher requirements on the contrast, luminance uniformity and stability of the display device. Display devices are generally divided into two types: liquid crystal display devices and organic light-emitting diode display devices. The liquid crystal display device is widely used due to its advantages of thinness, good shock resistance, wide viewing angle and high contrast. A liquid crystal display device generally comprises a display panel and a backlight, and the backlight is usually provided on a non-display side of the display panel to provide a light source for display of the display panel. The characteristics of the liquid crystal display device, such as contrast, luminance uniformity, and stability, are related to the structure and performance of the backlight.

### SUMMARY

According to an aspect of the present disclosure, a light-emitting substrate is provided. The light-emitting substrate comprises a substrate comprising a plurality of light-emitting regions arranged in an array, each of the plurality of light-emitting regions comprising a driving circuit and at least one light-emitting unit connected to the driving circuit; a first electrically conductive portion on the substrate and connected to the driving circuit and the at least one light-emitting unit in each light-emitting region; and a second electrically conductive portion on the substrate and comprising a plurality of pads. The first electrically conductive portion and the second electrically conductive portion are on a same layer.

In some embodiments, the plurality of light-emitting regions are arranged in M rows along a first direction and N columns along a second direction intersecting with the first direction, and both M and N are positive integers greater than or equal to 1. The first electrically conductive portion comprises N driving voltage signal lines and N common voltage signal lines extending along the first direction, each column of light-emitting regions comprises one driving voltage signal line and one common voltage signal line. In each column of light-emitting regions, the driving voltage signal line is connected to a first end of each light-emitting unit in the column of light-emitting regions, and the common voltage signal line is connected to each driving circuit in the column of light-emitting regions. In each column of light-emitting regions, the driving voltage signal line, the light-emitting unit, the driving circuit, and the common voltage signal line are sequentially arranged along the second direction.

In some embodiments, orthographic projections of the driving voltage signal line, the light-emitting unit, the driving circuit, and the common voltage signal line on the substrate do not overlap with each other.

In some embodiments, each driving circuit comprises a plurality of terminals arranged in an array, and the plurality of terminals are arranged in at least two columns along the second direction. The plurality of terminals comprise at least one output terminal and at least one common voltage terminal, the at least one output terminal and the at least one common voltage terminal are in different columns of the plurality of terminals. In each column of light-emitting regions, the at least one output terminal of each driving circuit is connected to a second end of the at least one light-emitting unit connected to the driving circuit in a one-to-one correspondence, and the at least one common voltage terminal of each driving circuit is connected to the common voltage signal line in the column of light-emitting regions.

In some embodiments, the plurality of terminals further comprise an address terminal, a relay terminal and a power terminal. The driving circuits in each column of light-emitting regions are cascaded in sequence, the address terminal of the i^{th}-cascaded driving circuit is on a side of the i^{th}-cascaded driving circuit close to the (i-1)^{th}-cascaded driving circuit, the relay terminal of the i^{th}-cascaded driving circuit is on a side of the i^{th}-cascaded driving circuit close to the (i+1)^{th}-cascaded driving circuit, 1<i<M and i is a positive integer. The address terminal is configured to receive an address signal, the relay terminal is configured to output a relay signal, and the power terminal is configured to receive a power voltage signal.

In some embodiments, an extending direction of the first electrically conductive portion is parallel to a cascade direction of the driving circuits.

In some embodiments, the plurality of terminals of the driving circuit are arranged in a first column and a second column along the second direction, in each column of light-emitting regions, the first column of terminals of the driving circuit is on a side of the driving circuit close to the driving voltage signal line, and the second column of terminals of the driving circuit is on a side of the driving circuit close to the common voltage signal line.

In some embodiments, the first electrically conductive portion further comprises N power signal lines, each column of light-emitting regions comprises one power signal line, each power signal line comprises a main portion and a first connection portion, and the main portion of the power signal line extends along the first direction. In each column of light-emitting regions, the power signal line is connected to the power terminal of each driving circuit in the column of light-emitting regions via the first connection portion, and an orthographic projection of the first column of terminals on the substrate and an orthographic projection of the second column of terminals on the substrate are respectively on both sides of an orthographic projection of the power signal line on the substrate.

In some embodiments, the first electrically conductive portion further comprises N address selection signal lines extending along the first direction, each column of light-emitting regions comprises one address selection signal line, in each column of light-emitting regions, the address selection signal line is connected to the address terminal of the first-cascaded driving circuit.

In some embodiments, the first electrically conductive portion further comprises a cascade wiring extending along the first direction, the cascade wiring is between two adjacent cascaded driving circuits in each column of light-emitting regions, and the relay terminal of the i^{th}-cascaded driving circuit is connected to the address terminal of the (i+1)^{th}-cascaded driving circuit via the cascade wiring.

In some embodiments, the first electrically conductive portion further comprises N feedback signal lines extending along the first direction, each column of light-emitting regions comprises one feedback signal line, in each column of light-emitting regions, the feedback signal line is connected to the relay terminal of the last-cascaded driving circuit, and the feedback signal line is at least partially on a side of the common voltage signal line away from the driving circuit in the column of light-emitting regions.

In some embodiments, orthographic projections of the driving voltage signal line, the address selection signal line, the cascade wiring, the power signal line, the common voltage signal line, and the feedback signal line on the substrate do not overlap with each other.

In some embodiments, the plurality of terminals of the driving circuit comprise the address terminal, the power terminal, the common voltage terminal, and the output terminal. The first column of terminals comprises the output terminal and the address terminal, and the second column of terminals comprises the common voltage terminal and the power terminal.

In some embodiments, the output terminal and the relay terminal of the driving circuit are a same terminal, the driving circuit is configured to, output a relay signal as the address signal of a next-cascaded driving circuit cascaded with the driving circuit via the output terminal during a first period, and provide a driving signal to the at least one light-emitting unit connected to the driving circuit via the output terminal during a second period.

In some embodiments, the plurality of terminals of the driving circuit further comprise a data terminal, and the data terminal and the power terminal are in different columns of the plurality of terminals.

In some embodiments, a number of the output terminals of the driving circuit is plural and a number of the common voltage terminal of the driving circuit is at least one. The first column of terminals comprises the power terminal and the plurality of output terminals, and the second column of terminals comprises the address terminal, the relay terminal, the data terminal, and the at least one common voltage terminal.

In some embodiments, the first electrically conductive portion further comprises N data driving signal lines, each column of light-emitting regions comprises one data driving signal line, each data driving signal line comprises a main portion and a second connection portion, the main portion of the data driving signal line extends along the first direction. In each column of light-emitting regions, the data driving signal line is connected to the data terminal of each driving circuit in the column of light-emitting regions via the second connection portion, and the orthographic projection of the first column of terminals on the substrate and the orthographic projection of the second column of terminals on the substrate are respectively on both sides of an orthographic projection of the data driving signal line on the substrate, and the orthographic projection of the data driving signal line on the substrate and the orthographic projection of the power signal line on the substrate do not overlap with each other.

In some embodiments, the plurality of output terminals of the driving circuit are connected to the second ends of the plurality of light-emitting units connected to the driving circuit in a one-to-one correspondence. The driving circuit is configured to, output a relay signal as the address signal of a next-cascaded driving circuit cascaded with the driving circuit via the relay terminal during a first period, and provide driving signals respectively to the plurality of light-emitting units via the plurality of output terminals during a second period.

In some embodiments, a spacing between the driving voltage signal line and another signal line adjacent to the driving voltage signal line is greater than or equal to 0.2 mm.

In some embodiments, the light-emitting substrate further comprises a plurality of flexible printed circuits and a fan-out area. Each signal line of the first electrically conductive portion comprises a straight portion and a bent portion, the bent portion of each signal line is within the fan-out area, and the signal lines are connected to the plurality of flexible printed circuits via the bent portions, and a width of the bent portion of each signal line along the second direction is smaller than a width of two adjacent columns of light-emitting regions along the second direction.

In some embodiments, an angle between the straight portion and the bent portion of each signal line is 80°~100°.

In some embodiments, a material of the first electrically conductive portion and the second electrically conductive portion comprises copper.

In some embodiments, each light-emitting unit comprises a plurality of light-emitting elements connected to each other, each of the plurality of light-emitting elements comprises a sub-millimeter light-emitting diode or a micro light-emitting diode.

In some embodiments, the light-emitting substrate further comprises a shielding ring. The shielding ring surrounds the periphery of the plurality of light-emitting regions, and an electrical signal received by the shielding ring and an electrical signal received by the common voltage signal line are the same.

In some embodiments, the light-emitting substrate further comprises a buffer layer and an insulating layer. The buffer layer is between a layer where the first electrically conductive portion and the second electrically conductive portion are located and the substrate. The insulating layer is on a side of the layer where the first electrically conductive portion and the second electrically conductive portion are located away from the substrate.

According to another aspect of the present disclosure, a backlight is provided. The backlight comprises the light-emitting substrate described in any of the preceding embodiments.

According to still another aspect of the present disclosure, a display device is provided. The display device comprises the light-emitting substrate described in any of the preceding embodiments.

According to yet another aspect of the present disclosure, there is provided a method of manufacturing a light-emitting substrate, the method comprising the steps of: providing a substrate; forming an electrically conductive layer on the substrate, patterning the electrically conductive layer to simultaneously form a first electrically conductive portion and a second electrically conductive portion comprising a plurality of pads; and mounting a plurality of driving circuits and a plurality of light-emitting units on the substrate to form a plurality of light-emitting regions arranged in an array, each of the plurality of light-emitting regions comprising a driving circuit and at least one light-emitting unit connected to the driving circuit. The first electrically conductive portion is connected to the driving circuit and the at least one light-emitting unit in each light-emitting region.

### BRIEF DESCRIPTION OF THE DRAWINGS

In order to describe the technical solutions in the embodiments of the present disclosure more clearly, the accompanying drawings required in the embodiments will be briefly introduced below. Obviously, the drawings described in the following are only some embodiments of the present disclosure. For those of ordinary skill in the art, other drawings can also be obtained from these drawings without any creative effort.
FIG. 1 illustrates a schematic diagram of the arrangement of a light-emitting substrate provided according to an embodiment of the present disclosure;
FIG. 2 illustrates a schematic diagram of wiring of a light-emitting substrate provided according to an embodiment of the present disclosure;
FIG. 3 illustrates a schematic diagram of the arrangement of terminals of the driving circuit of the light-emitting substrate in FIG. 2;
FIG. 4 illustrates a schematic diagram of the arrangement of the first pad of the light-emitting substrate in FIG. 2;
FIG. 5 illustrates a partial enlarged view of FIG. 2;
FIG. 6 illustrates a schematic diagram of wiring of a light-emitting substrate provided according to an embodiment of the present disclosure;
FIG. 7 illustrates a schematic diagram of wiring of a light-emitting substrate provided according to another embodiment of the present disclosure;
FIG. 8 illustrates a schematic diagram of the arrangement of the first pad of the light-emitting substrate in FIG. 7;
FIG. 9 illustrates a partial enlarged view of FIG. 7;
FIG. 10 illustrates a partial enlarged view of FIG. 9;
FIG. 11A illustrates a schematic diagram of the arrangement of a flexible printed circuit of a light-emitting substrate provided according to an embodiment of the present disclosure;
FIG. 11B illustrates a partial enlarged view of region I in FIG. 11A;
FIG. 12 illustrates a schematic diagram of the arrangement of light-emitting units of a light-emitting substrate provided according to an embodiment of the present disclosure;
FIG. 13 illustrates a schematic structural diagram of a light-emitting substrate provided according to an embodiment of the present disclosure;
FIG. 14 illustrates a block diagram of a backlight provided according to yet another embodiment of the present disclosure;
FIG. 15 illustrates a block diagram of a display device provided according to still another embodiment of the present disclosure; and
FIG. 16 illustrates a flowchart of a method for manufacturing a light-emitting substrate according to yet another embodiment of the present disclosure.

### DETAILED DESCRIPTION OF THE DISCLOSURE

The technical solutions in the embodiments of the present disclosure will be clearly and completely described below with reference to the accompanying drawings in the embodiments of the present disclosure. Obviously, the described embodiments are only some, but not all, embodiments of the present disclosure. Based on the embodiments in the present disclosure, all other embodiments obtained by those of ordinary skill in the art without creative efforts shall fall within the protection scope of the present disclosure.

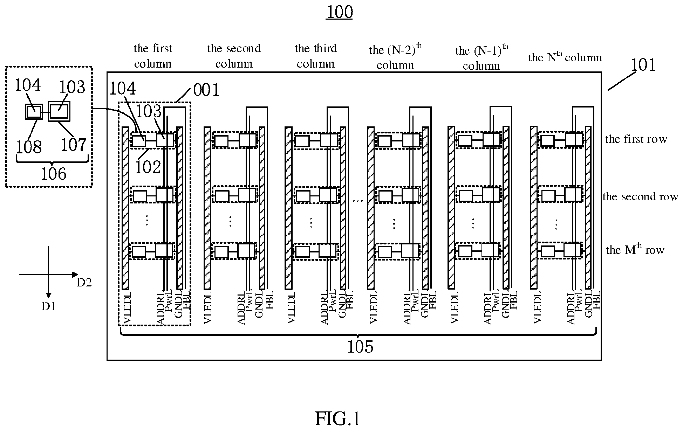

An embodiment of the present disclosure provides a light-emitting substrate, and FIG. 1 illustrates a schematic diagram of the arrangement of the light-emitting substrate 100. As illustrated in FIG. 1, the light-emitting substrate 100 comprises a substrate 101, a first electrically conductive portion 105 and a second electrically conductive portion 106 arranged on the substrate 101. The substrate 101 comprises a plurality of light-emitting regions 102 arranged in an array, and each light-emitting region 102 comprises a driving circuit 103 and at least one light-emitting unit 104 connected to the driving circuit 103. The first electrically conductive portion 105 is connected to the driving circuit 103 and the light-emitting unit 104 in each light-emitting region 102, for example, the first electrically conductive portion 105 may comprise a plurality of signal lines. The dotted box on the left side of FIG. 1 illustrates an enlarged view of a light-emitting region 102. As illustrated in the enlarged view, the second electrically conductive portion 106 comprises a plurality of pads, and the plurality of pads comprise, for example, a plurality of first pads 107 and a plurality of second pads 108. The driving circuit 103 is mounted on the first pads 107, and the light-emitting unit 104 is mounted on the second pads 108. The first electrically conductive portion 105 and the second electrically conductive portion 106 are located on the same layer. It should be noted that, in the present application, the term "A and B are located on the same layer" means that A and B are located on and in direct contact with the surface of the same layer. In some embodiments, A and B are formed of the same layer through the same process. In some embodiments, A and B are located on and in direct contact with the surface of the same layer, and A and B have substantially the same height or thickness.

It can be understood that FIG. 1 is only used to schematically illustrate the connection relationship between the driving circuit 103, the light-emitting unit 104, and the first electrically conductive portion 105 and the second electrically conductive portion 106. The dimensions of the driving circuit 103, the light-emitting unit 104, the first electrically conductive portion 105 and the second electrically conductive portion 106 are not drawn to scale, and their relative positional relationships do not necessarily correspond exactly to actual positions. In the drawings, the scale of certain regions and layers may be exaggerated for clarity.

By making the first electrically conductive portion 105 and the second electrically conductive portion 106 on the same layer, a single electrically conductive layer can not only be used to fabricate the first pad 107 and the second pad 108 of the second electrically conductive portion 106 and the wiring connecting the driving circuit 103 and the light-emitting unit 104, but also be used to fabricate a plurality of signal lines of the first electrically conductive portion 105 to transmit corresponding electrical signals to the driving circuit 103 and the light-emitting unit 104 in each light-emitting region 102. In contrast, in the related art, at least two electrically conductive layers are usually used to achieve the above-mentioned electrical connection relationship, that is, the first pad and the second pad are made from a first electrically conductive layer, and the signal lines are made from a second electrically conductive layer located at a different layer from the first electrically conductive layer to transmit corresponding electrical signals. Since the first electrically conductive layer and the second electrically conductive layer inevitably overlap in the direction perpendicular to the substrate, and the overlapping area of the two is a weak area, so a short circuit or an open circuit is very likely to occur between the first electrically conductive layer and the second electrically conductive layer, thereby affecting the light-emitting performance of the light-emitting substrate. Moreover, when preparing the first electrically conductive layer and the second electrically conductive layer located at different layers, different masks need to be used, which greatly increases the production cost. Compared with the related art, the first electrically conductive portion 105 and the second electrically conductive portion 106 of the present application are located on the same layer. On the one hand, since the single electrically conductive layer does not have the overlapping problem of the two electrically conductive layer, a short circuit or an open circuit caused by the overlap of the first electrically conductive portion 105 and the second electrically conductive portion 106 in the direction perpendicular to the substrate 101 can be completely avoided, so that the light-emitting performance of the light-emitting substrate 100 can be improved, and the light-emitting stability of the light-emitting substrate 100 can be improved. On the other hand, during the manufacturing process, the first electrically conductive portion 105 and the second electrically conductive portion 106 can be formed simultaneously from the same material and through the same process, so the number of masks can be reduced, the production cost can be reduced, the manufacturing process can be simplified and the production efficiency can be improved.

As illustrated in FIG. 1, the plurality of light-emitting regions 102 are arranged in M rows along a first direction D1 and N columns along a second direction D2 intersecting with the first direction D1, where M and N are both positive integers greater than or equal to 1. The first direction D1 may be the vertical direction in the figure, the second direction D2 may be the horizontal direction in the figure, and the first direction D1 and the second direction D2 may be perpendicular to each other. The first electrically conductive portion 105 comprises N driving voltage signal lines VLEDL and N common voltage signal lines GNDL extending along the first direction D1, so that each column of light-emitting regions 001 comprises one driving voltage signal line VLEDL and one common voltage signal line GNDL. In each column of light-emitting regions 001, one driving voltage signal line VLEDL is connected to a first end of each light-emitting unit 104 in the column of light-emitting regions 001, and one common voltage signal line GNDL is connected to each driving circuit 103 in the column of light-emitting regions 001. The driving voltage signal line VLEDL is configured to provide a driving voltage to the light-emitting unit 104, and the common voltage signal line GNDL is configured to provide a common voltage (e.g., a ground voltage) to the driving circuit 103, for example, when the light-emitting unit 104 in a certain light-emitting region 102 needs to emit light, the driving voltage is a high voltage and the common voltage is a low voltage, so that a voltage difference is generated on both sides of the light-emitting unit 104, so as to drive the light-emitting unit 104 to emit light. In each column of light-emitting regions 001, the driving voltage signal line VLEDL, the light-emitting unit 104, the driving circuit 103, and the common voltage signal line GNDL are sequentially arranged along the second direction D2. Taking the first column of light-emitting regions 001 in FIG. 1 as an example, the light-emitting units 104 (i.e., the 1^{st} ~ M^{th} rows of light-emitting units 104) in the column of light-emitting regions 001 are arranged in a column of light-emitting units, the driving circuits 103 (i.e., the 1^{st} ~ M^{th} rows of driving circuits 103) in the column of light-emitting regions 001 are arranged in a column of driving circuits. The driving voltage signal line VLEDL, the column of light-emitting units, the column of driving circuits, and the common voltage signal line GNDL are sequentially arranged from left to right along the second direction D2 in the figure. In some embodiments, in each column of light-emitting regions 001, the orthographic projections of the driving voltage signal line VLEDL, the column of light-emitting units, the column of driving circuits, and the common voltage signal line GNDL on the substrate 101 do not overlap with each other. With such an arrangement, a short circuit or an open circuit between the driving voltage signal line VLEDL and the common voltage signal line GNDL of the first electrically conductive portion 105 and the first pad 107 and the second pad 108 of the second electrically conductive portion 106 can be completely avoided, so that the light-emitting performance of the light-emitting substrate 100 can be improved, and the light-emitting stability of the light-emitting substrate 100 can be improved.

The driving circuit 103 may be an integrated circuit, especially a packaged chip with multiple terminals. The driving circuit 103 may comprise one output terminal, or may comprise at least two output terminals, for example, two output terminals, three output terminals, four output terminals, or more output terminals. Compared with the related art, the arrangement of the terminals of the driving circuit 103 of the present application is optimized, so as to better match with the wiring of each signal line, so that there is no overlap between the signal lines whether in the direction perpendicular to the substrate 101 or in the direction parallel to the substrate 101.

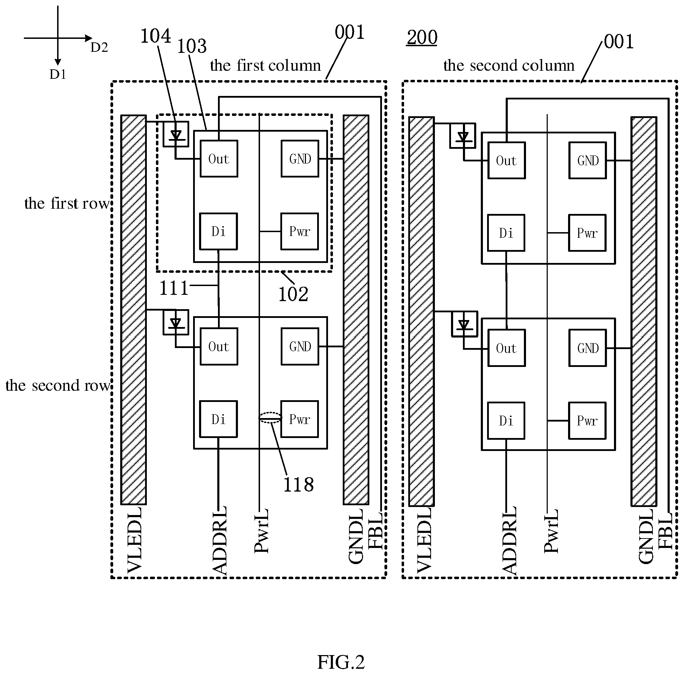

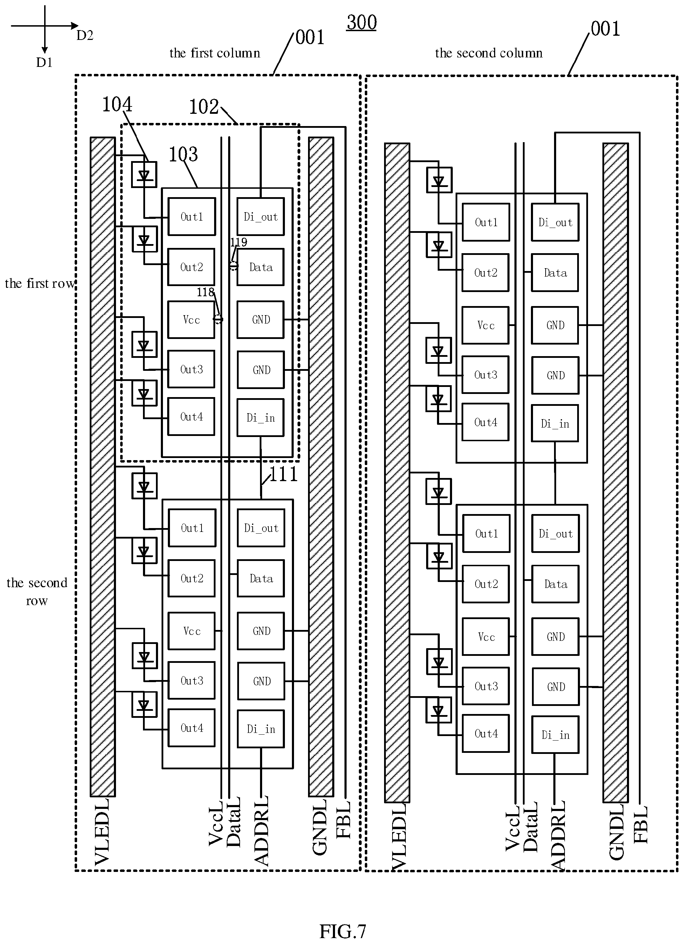

Hereinafter, some common characteristics of the light-emitting substrate 200 and the light-emitting substrate 300 will be described with reference to FIGS. 2 and 7.

As shown in FIGS. 2 and 7, each driving circuit 103 comprises a plurality of terminals arranged in an array along the first direction D1 and the second direction D2, and the plurality of terminals are arranged in at least two columns along the second direction D2. The plurality of terminals comprise at least one output terminal Out and at least one common voltage terminal GND, and the at least one output terminal Out and the at least one common voltage terminal GND are located in different columns of the plurality of terminals. In each column of light-emitting regions 001, at least one output terminal Out of each driving circuit 103 is connected to a second end of at least one light-emitting unit 104 connected to the driving circuit 103 in a one-to-one correspondence, so as to transmit a driving signal to the at least one light-emitting unit 104; at least one common voltage terminal GND of each driving circuit 103 is connected to the common voltage signal line GNDL to receive a common voltage (e.g., a ground voltage) transmitted by the common voltage signal line GNDL.

The driving circuit 103 further comprises an address terminal Di/Di_in, a relay terminal Out/Di_out, and a power terminal Pwr/Vcc. The driving circuits 103 in each column of light-emitting regions 001 are cascaded in sequence, the address terminal Di/Di_in of the i^{th}-cascaded driving circuit 103 is located on a side of the i^{th}-cascaded driving circuit 103 close to the (i-1)^{th}-cascaded driving circuit 103, the relay terminal Out/Di_out of the i^{th}-cascaded driving circuit 103 is located on a side of the i^{th}-cascaded driving circuit 103 close to the (i+1)^{th}-cascaded driving circuit 103, where 1<i<M and i is a positive integer. In the embodiment of the present disclosure, the driving circuits 103 in each column of light-emitting regions 001 are cascaded in sequence from bottom to top along the first direction D1, and the i^{th}-cascaded driving circuit 103 refers to the i^{th} driving circuit 103 counting upwards from the M^{th} row of driving circuit 103 in each column of light-emitting regions 001. For example, taking the first column of light-emitting regions 001 as an example, the driving circuit 103 located in the 1^{st} column and the M^{th} row is the 1^{st}-cascaded driving circuit, and the driving circuit 103 located in the 1^{st} column and the (M-1)^{th} row is the 2^{nd}-cascaded driving circuit. By analogy, the driving circuit 103 located in the 1^{st} column and the 2^{nd} row is the (M-1)^{th}-cascaded driving circuit, and the driving circuit 103 located in the 1^{st} column and the 1^{st} row is the M^{th}-cascaded driving circuit. In the driving circuit 103 illustrated in FIG. 2, the address terminal is Di, the relay terminal is Out, and the power terminal is Pwr. In the driving circuit 103, the output terminal Out is multiplexed as a relay terminal, that is, the output terminal Out and the relay terminal are the same terminal, and the output terminal Out outputs different signals in different time periods, for example, outputs a relay signal as a relay terminal and outputs a drive signal as an output terminal, respectively. In the driving circuit 103 illustrated in FIG. 7, the address terminal is Di_in, the relay terminal is Di_out, and the power terminal is Vcc. In this driving circuit 103, the output terminal Out and the relay terminal Di_out are two different terminals. The address terminals Di/Di_in are configured to receive address signals, the relay terminals Out/Di_out are configured to output relay signals, and the power terminals Pwr/Vcc are configured to receive power voltage signals. The plurality of terminals of the driving circuit 103 are arranged in a 1^{st} column and a 2^{nd} column along the second direction D2, and in each column of light-emitting regions 001, the first column of terminals of the driving circuit 103 is located on a side of the driving circuit 103 close to the driving voltage signal line VLEDL (i.e., on the left side of the driving circuit 103), the second column of terminals of the driving circuit 103 is located on a side of the driving circuit 103 close to the common voltage signal line GNDL (i.e. on the right side of the driving circuit 103). Such arrangement of the terminals of the driving circuit 103 is beneficial to promote the regular arrangement of the signal lines, so that the signal lines do not overlap each other, so that short circuit/open circuit or signal crosstalk caused by the overlap between the signal lines can be avoided.

As illustrated in FIG. 2 and FIG. 7, the first electrically conductive portion 105 further comprises N address selection signal lines ADDRL extending along the first direction D1, so that each column of light-emitting regions 001 comprises one address selection signal line ADDRL. Although FIG. 2 and FIG. 7 only illustrate that the light-emitting substrate comprises four light-emitting regions 102, and the four light-emitting regions 102 are arranged in a manner of 2 rows*2 columns, these is only a part of the light-emitting substrate, and the light-emitting substrate generally comprises a plurality of light-emitting regions 102, the plurality of light-emitting regions 102 are arranged in M rows and N columns, where M and N are any positive integers greater than or equal to 1. Therefore, each column of light-emitting regions 001 comprises a plurality of driving circuits 103, and the plurality of driving circuits 103 are cascaded in sequence through a cascade wiring 111 extending along the first direction D1. The address selection signal line ADDRL is connected to the address terminal Di/Di_in of the first-cascaded driving circuit 103, and the relay terminal Out/Di_out of the previous-cascaded driving circuit is connected to the address terminal Di/Di_in of the next-cascaded driving circuit 103 via the cascade wiring 111. In the example of FIG. 2, each column of light-emitting regions 001 is illustrated as comprising two driving circuits 103, and the two driving circuits 103 are cascaded in sequence through the cascade wiring 111 extending along the first direction D1. The address selection signal line ADDRL is connected to the address terminal Di of the first-cascaded driving circuit 103, and the relay terminal Out of the first-cascaded driving circuit is connected to the address terminal Di of the second-cascaded driving circuit 103 via the cascade wiring 111. In the example of FIG. 7, each column of light-emitting regions 001 is illustrated to comprise two driving circuits 103, and the two driving circuits 103 are cascaded in sequence through the cascade wiring 111 extending along the first direction D1. The address selection signal line ADDRL is connected to the address terminal Di_in of the first-cascaded driving circuit 103, and the relay terminal Di_out of the first-cascaded driving circuit is connected to the address terminal Di_in of the second-cascaded driving circuit 103 via the cascade wiring 111.

The address selection signal line ADDRL is configured to transmit an address signal to the address terminal Di/Di_in of the first-cascaded driving circuit 103 in each column of light-emitting regions 001. After the first-cascaded driving circuit 103 receives the address signal, the address information in the address signal can be parsed, obtained, and stored as the address information of the first-cascaded driving circuit 103, at the same time, the address information can also be incremented by 1 or incremented by another fixed value, and the incremented address information (new address information) can be modulated into a relay signal. The relay terminal Out/Di_out of the first-cascaded driving circuit 103 transmits the relay signal to the address terminal Di/Di_in of the second-cascaded driving circuit 103 via the cascade wiring 111 to serve as the address information of the second-cascaded driving circuit 103. Of course, the first-cascaded driving circuit 103 can also use any other appropriate function to transform its address information to generate the relay signal. The second-cascaded driving circuit 103 transmits the relay signal to the third-cascaded driving circuit 103 in a similar manner as the address information of the third-cascaded driving circuit 103, and so on. In this way, corresponding address information can be configured for each of the plurality of cascaded driving circuits 103 in each column of light-emitting regions 001. It can be seen that, for a column of light-emitting regions 001, only one address signal needs to be provided through one address selection signal line ADDRL, so that all the driving circuits 103 in the column of light-emitting regions 001 can obtain their respective address information. This greatly reduces the number of signal lines, saves wiring space, and simplifies control methods.

As illustrated in FIG. 2 and FIG. 7, the first electrically conductive portion 105 further comprises N feedback signal lines FBL extending along the first direction D1, and each column of light-emitting regions 001 comprises one feedback signal line FBL. In each column of light-emitting regions 001, the feedback signal line FBL is connected to the relay terminal Out/Di_out of the last-cascaded driving circuit 103. The feedback signal line FBL bypasses the common voltage signal line GNDL in the column of light-emitting regions 001 and is located on a side of the common voltage signal line GNDL away from the driving circuit 103.

The first electrically conductive portion 105 further comprises N power signal lines PwrL/VccL, and each column of light-emitting regions 001 comprises one power signal line PwrL/VccL. Each power signal line PwrL/VccL comprises a main portion and a first connection portion 118, and the main portion of the power signal line PwrL/VccL extends along the first direction D1. In each column of light-emitting regions 001, one power signal line PwrL/VccL is connected to the power terminals Pwr/Vcc of all the driving circuits 103 in the column of light-emitting regions 001 via the first connection portion 118, and the orthographic projection of the first column of terminals of each driving circuit 103 on the substrate 101 and the orthographic projection of the second column of terminals of each driving circuit 103 on the substrate 101 are respectively located on both sides of the orthographic projection of the power signal line PwrL/VccL on the substrate 101. That is, the power signal line PwrL/VccL is arranged within the area occupied by each driving circuit 103 and does not overlap with the first column of terminals and the second column of terminals of each driving circuit 103. By arranging the power signal line PwrL/VccL in each column of light-emitting regions 001 in the area occupied by each driving circuit 103, wiring space can be saved, and the overlap between the power signal line PwrL/VccL and other signal lines can be avoided.

It should be noted that, in the embodiments of the present disclosure, the signal line generally comprises a main portion and a connection portion, the main portion defines the main extension direction of the signal line, and the connection portion is used for connecting the signal line with the required components. For example, the driving voltage signal line VLEDL is connected to the second end of the light-emitting unit 104 via its connection portion; the power signal line PwrL/VccL is connected to the power terminal Pwr/Vcc of the driving circuit 103 via the first connection portion 118; the common voltage signal line GNDL is connected to the common voltage terminal GND of the driving circuit 103 via its connection portion. The connection portion of each signal line has a small proportion in length or width compared to its main portion. Therefore, in the specification of the present application, phrases such as "the X signal line extending along the first direction D1" only define that the main portion of the X signal line extends along the first direction D 1, but does not define that the connection portion of the X signal line extends along the first direction D1. For example, the main portion of each power signal line PwrL/VccL extends along the first direction D1, while its first connection portion 118 does not extend along the first direction D1, but extends along the direction (e.g., the second direction D2) intersecting with the first direction D 1.

In each column of light-emitting regions 001, the power signal line PwrL/VccL is configured to transmit a power voltage signal to the power terminal Pwr/Vcc of each driving circuit 103, thereby supplying each driving circuit 103 with a power voltage. In an example, the power voltage signal is a power line carrier communication signal. In this case, the power signal line PwrL/VccL can not only supply the power voltage to each driving circuit 103, but also supply communication data to each driving circuit 103, and the communication data can be used to control the light-emitting duration of at least one light-emitting unit 104 connected to the driving circuit 103 and to further control its visual light-emitting brightness. The power line carrier communication signal contains information corresponding to the communication data. For example, the communication data is data reflecting the light-emitting duration, and further represents the required lighting brightness. Compared with the common serial peripheral interface (SPI) protocol, the embodiment of the present disclosure superimposes the communication data on the power signal line PwrL/VccL by using the power line carrier communication (PLC) protocol, thereby effectively reducing the number of signal lines.

It can be seen from the examples in FIG. 2 and FIG. 7 that the terminals of the driving circuit 103 are arranged as described above, so that in each column of light-emitting regions 001, the orthographic projections of the driving voltage signal line VLEDL, the address selection signal line ADDRL, the cascade wiring 111, the power signal line PwrL/VccL, the common voltage signal line GNDL, and the feedback signal line FBL of the first electrically conductive portion 105 on the substrate 101 do not overlap with each other. In addition, the orthographic projections of the driving voltage signal line VLEDL, the common voltage signal line GNDL, and the feedback signal line FBL of the first electrically conductive portion 105 on the substrate 101 and the orthographic projections of the first pads 107 and the second pads 108 of the second electrically conductive portion 106 on the substrate 101 also do not overlap. In this way, the short circuit or open circuit caused by the overlapping of the first electrically conductive portion 105 and the second electrically conductive portion 106 on the same layer can be completely avoided, thereby improving the light-emitting performance of the light-emitting substrate and improving the light-emitting stability of the light-emitting substrate.

Some common characteristics of the light-emitting substrate 200 and the light-emitting substrate 300 have been described above. Below, two examples are used to describe the specific arrangement of the light-emitting substrate 200 and the specific arrangement of the light-emitting substrate 300 respectively.

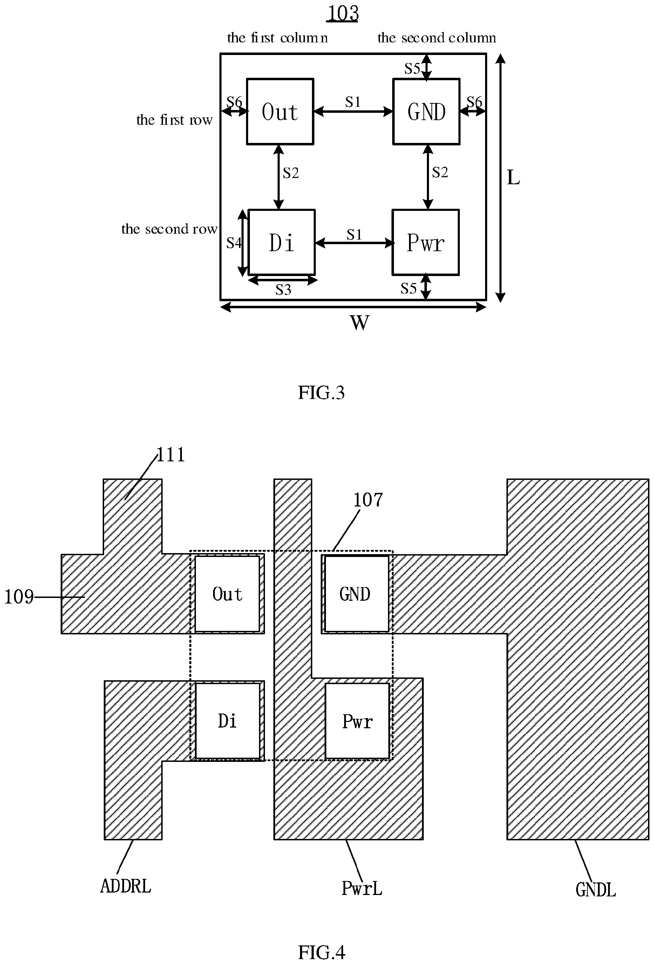

FIG. 2 illustrates the arrangement of the light-emitting substrate 200. Although FIG. 2 only illustrates four light-emitting regions 102 arranged in 2 rows*2 columns, this is only a part of the light-emitting substrate 200, and the light-emitting substrate 200 may comprise any appropriate number of light-emitting regions 102 which may be arranged in multiple rows and multiple columns. The embodiment of the present disclosure does not specifically limit the number of the light-emitting regions 102 comprised by the light-emitting substrate 200. As illustrated in the figure, each light-emitting region 102 comprises one driving circuit 103 and one light-emitting unit 104 connected to the driving circuit 103. FIG. 3 illustrates the arrangement of the terminals of the driving circuit 103.

As illustrated in FIGS. 2 and 3, each driving circuit 103 comprises four terminals, which are an address terminal Di, a power terminal Pwr, a common voltage terminal GND, and an output terminal Out, respectively. The output terminal Out and the address terminal Di are the first column of terminals of the driving circuit 103, which are located on the side of the driving circuit 103 close to the driving voltage signal line VLEDL (i.e., on the left side of the driving circuit 103); the common voltage terminal GND and the power terminal Pwr are the second column of terminals of the driving circuit 103, which is located on the side of the driving circuit 103 close to the common voltage signal line GNDL (i.e., on the right side of the driving circuit 103). The address terminal Di and the power terminal Pwr are located in the second row of the plurality of terminals, and the common voltage terminal GND and the output terminal Out are located in the first row of the plurality of terminals. As mentioned above, the output terminal Out is multiplexed as a relay terminal. In each column of light-emitting regions 001, one end of the output terminal Out of the first-cascaded driving circuit 103 (i.e., the driving circuit 103 located in the second row and the first column in FIG. 2) is connected to the light-emitting unit 104 corresponding to the driving circuit 103, and the other end is connected to the address terminal Di of the second-cascaded driving circuit 103 (i.e., the driving circuit 103 located in the first row and the first column in FIG. 2) via the cascade wiring 111. One end of the output terminal Out of the second-cascaded driving circuit 103 is connected to the light-emitting unit 104 corresponding to the driving circuit 103, and the other end is connected to the feedback line FBL. The output terminal Out can output different signals respectively in different time periods. For example, in one period, the output terminal Out of the driving circuit 103 outputs a relay signal as an address signal for the next-cascaded driving circuit 103 cascaded with the driving circuit 103, and in another period, the output terminal Out of the driving circuit 103 provides a driving signal to the light-emitting unit 104 connected to the driving circuit 103 to cause the light-emitting unit 104 to emit light. The one period and another period are two separate periods, e.g. the another period immediately follows the one period. The driving signal may be, for example, a driving current for driving the light-emitting unit 104 to emit light. It should be noted that when the driving signal is a driving current, the driving current can flow from the output terminal Out to the light-emitting unit 104, or flow from the light-emitting unit 104 to the output terminal Out, and the flow direction of the driving current can be determined according to actual needs, which is not limited by the embodiments of the present disclosure.

The spacing between the various terminals of the driving circuit 103 of the light-emitting substrate 200 is usually determined according to many factors (such as process limit capability, line width requirements between two columns of terminals, electrical design requirements, etc.), and the embodiments of the present disclosure do not specifically limit this. For example, the spacing between the first column of terminals and the second column of terminals may be 70-300 µm, and the spacing between the first row of terminals and the second row of terminals may be 70-300 µm. As illustrated in FIG. 3, in an example, the spacing S 1 between the first column of terminals and the second column of terminals is 140 µm, and the spacing S2 between the first row of terminals and the second row of terminals is 120 µm. That is to say, the spacing between the output terminal Out and the common voltage terminal GND is 140 µm, the spacing between the address terminal Di and the power terminal Pwr is 140 µm; the spacing between the output terminal Out and the address terminal Di is 120 µm, and the spacing between the common voltage terminal GND and the power terminal Pwr is 120 µm. The four terminals of the driving circuit 103 occupy substantially the same area, and have substantially the same length and width. The width S3 of each terminal along the second direction D2 is 80 µm, and the length S4 of each terminal along the first direction D1 is 100 µm. The spacing S5 between the second row of terminals and the first side of the driving circuit 103 (i.e., the lower edge of the driving circuit 103 ) is 25 µm, that is, the spacing S5 between the address terminal Di and the power terminal Pwr and the lower edge of the driving circuit 103 is 25 µm; the spacing S5 between the first row of terminals and the second side of the driving circuit 103 (i.e., the upper edge of the driving circuit 103 ) is 25 µm, that is, the spacing S5 between the output terminal Out and the common voltage terminal GND and the upper edge of the driving circuit 103 is 25 µm. The spacing S6 between the first column of terminals and the third side of the driving circuit 103 (i.e. the left edge of the driving circuit 103 ) is 25 µm, that is, the spacing S6 between the output terminal Out and the address terminal Di and the left edge of the driving circuit 103 is 25 µm; the spacing S6 between the second column of terminals and the fourth side of the driving circuit 103 (i.e., the right edge of the driving circuit 103 ) is 25 µm, that is, the spacing S6 between the common voltage terminal GND and the power terminal Pwr and the right edge of the driving circuit 103 is 25 µm. Therefore, it can be known that the length L of the driving circuit 103 along the first direction D1 is 370 µm, and the width W of the driving circuit 103 along the second direction D2 is 350 µm. In each column of light-emitting regions 001, the spacing between the power signal line PwrL and the first column of terminals and the second column of terminals may be 10-100 µm, respectively. In an example, the width of the power signal line PwrL between the first column of terminals and the second column of terminals along the second direction D2 is greater than or equal to 40 µm.

In the example of FIG. 2, each column of light-emitting regions 001 comprises the driving voltage signal line VLEDL, the address selection signal line ADDRL, the cascade wiring 111, the power signal line PwrL, the common voltage signal line GNDL, and the feedback signal line FBL. These signal lines do not overlap with each other in either the direction perpendicular to the substrate 101 or the direction parallel to the substrate 101. The functions and arrangement of these signal lines are as described above, and are not repeated here for the sake of brevity.

Hereinafter, the working mode of the light-emitting substrate 200 in FIG. 2 will be briefly described.

When the driving circuit 103 starts to work, the power terminal Pwr of each driving circuit 103 in each column of light-emitting regions 001 is provided with power voltage via the power signal line PwrL to complete the initialization. Thus, the driving circuit 103 is powered on.

Next, the address writing operation is performed in the first period, that is, the ADDRL signal line inputs the address signal to the first-cascaded driving circuit 103 via the address terminal Di, thereby writing the address.

Next, in the second period, the driving configuration is performed, and the first-cascaded driving circuit 103 outputs a relay signal via the output terminal Out, and the relay signal is transmitted to the address terminal Di of the second-cascaded driving circuit 103 via the cascade wiring 111 as the address signal of the second-cascaded driving circuit 103. And so on, until all the driving circuits 103 complete the address information configuration.

Then, in the third period, the driving voltage is supplied to the driving voltage signal line VLEDL. For example, the third period is entered after the plurality of driving circuits 103 have obtained the corresponding address information. At this time, the driving voltage transmitted on the driving voltage signal line VLEDL becomes a high level.

Next, in the fourth period, the output terminal Out of each driving circuit 103 provides a driving signal (e.g., driving current) according to the required light-emitting duration. At this time, the driving voltage signal line VLEDL, the light-emitting unit 104, the output terminal Out electrically connected to the light-emitting unit 104, and the common voltage signal line GNDL constitute a signal loop, and the light-emitting unit 104 emits light according to the required light-emitting duration.

Finally, in the fifth period, the system is turned off, that is, the driving circuit 103 is powered off, and the driving voltage provided by the driving voltage signal line VLEDL becomes a low level, and the light-emitting unit 104 stops emitting light.

The light-emitting substrate 200 illustrated in FIG. 2 can realize zone dimming. The light-emitting substrate 200 comprises a plurality of light-emitting regions 102, and each light-emitting region comprises one driving circuit 103 and one light-emitting unit 104 connected to and controlled by the driving circuit 103, so that the light-emitting brightness of each light-emitting unit 104 can be independently controlled. For example, by setting the address signal and the power voltage signal provided to each driving circuit 103, the light-emitting duration of the light-emitting unit 104 connected to each driving circuit 103 can be controlled separately, thereby controlling the visual light-emitting brightness. The light-emitting substrate 200 can realize the independent control of light-emitting brightness in different regions, and has a wide application range. In addition, each driving circuit 103 has a small number of ports and requires few control signals, so the control method is simple, the power consumption is small, and the operation is convenient. The light-emitting substrate 200 has a high degree of integration, and can cooperate with a liquid crystal display device to realize high-contrast display.

FIG. 4 illustrates the arrangement of the first pad 107 and its surrounding wirings. The driving circuit 103 illustrated in FIG. 2 is mounted on the first pad 107 and the first pad 107 is electrically connected to the driving circuit 103. The first pad 107 is provided with four sub-pads at positions corresponding to the four terminals of the driving circuit 103, respectively, which are a first sub-pad for mounting the address terminal Di, a second sub-pad for mounting the power terminal Pwr, a third sub-pad for mounting the common voltage terminal GND, and a fourth sub-pad for mounting the output terminal Out. The first sub-pad is connected to the address terminal Di of the driving circuit 103, the second sub-pad is connected to the power terminal Pwr of the driving circuit 103, the third sub-pad is connected to the common voltage terminal GND of the driving circuit 103, and the fourth sub-pad is connected to the output terminal Out of the driving circuit 103. The first sub-pad is connected to the address selection signal line ADDRL to transmit the address signal on the address selection signal line ADDRL to the address terminal Di. The second sub-pad is connected to the power signal line PwrL to transmit the power voltage signal on the power signal line PwrL to the power terminal Pwr. The third sub-pad is connected to the common voltage signal line GNDL to transmit the common voltage signal on the common voltage signal line GNDL to the common voltage terminal GND. One end of the fourth sub-pad is connected to the cascade wiring 111 to output a relay signal during a period as the address signal of the next-cascaded driving circuit 103 cascaded with the driving circuit 103; the other end of the fourth sub-pad is connected to the wiring 109 to transmit the driving signal to the light-emitting unit 104 connected to the driving circuit 103 via the wiring 109 in another period.

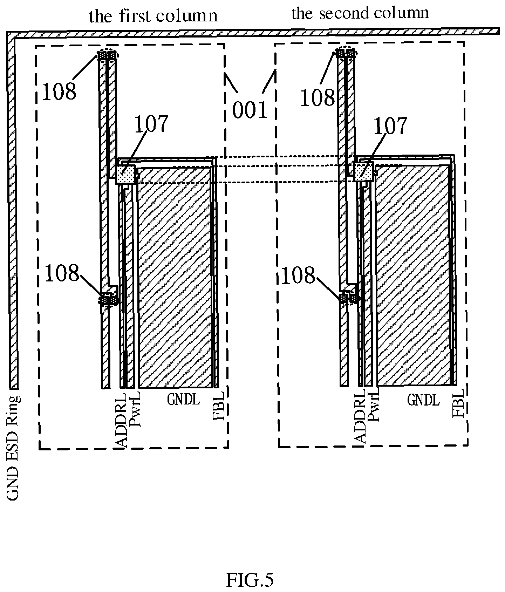

FIG. 5 is a partial schematic view of FIG. 2, illustrating two columns of light-emitting regions 001. In each column of light-emitting regions 001, four second pads 108 are sequentially connected in series and connected to the first pad 107. The address selection signal line ADDRL, the power signal line PwrL, the common voltage signal line GNDL, and the feedback signal line FBL are shown in each column of light-emitting regions 001, and the driving voltage signal line VLEDL is not shown, but as described above, each column of light-emitting regions 001 comprises the driving voltage signal line VLEDL, which is not illustrated in the figure. As illustrated in the figure, one end of the address selection signal line ADDRL in the first column of light-emitting regions 001 close to the first pad 107 is substantially flush with one end of the address selection signal line ADDRL in the second column of light-emitting regions 001 close to the first pad 107, that is, the address selection signal line ADDRL in the first column of light-emitting regions 001 and the address selection signal line ADDRL in the second column of light-emitting regions 001 have substantially the same length; one end of the power signal line PwrL in the first column of light-emitting regions 001 close to the first pad 107 is substantially flush with one end of the power signal line PwrL in the second column of light-emitting regions 001 close to the first pad 107, that is, the power signal line PwrL in the first column of light-emitting regions 001 and the power signal line PwrL in the second column of light-emitting regions 001 have substantially the same length; one end of the common voltage signal line GNDL in the first column of light-emitting regions 001 close to the first pad 107 is substantially flush with one end of the common voltage signal line GNDL in the second column of light-emitting regions 001 close to the first pad 107, that is, the common voltage signal line GNDL in the first column of light-emitting regions 001 and the common voltage signal line GNDL in the second column of light-emitting regions 001 have substantially the same length; one end of the feedback signal line FBL in the first column of light-emitting regions 001 close to the first pad 107 is substantially flush with one end of the feedback signal line FBL in the second column of light-emitting regions 001 close to the first pad 107, that is, the feedback signal line FBL in the first column of light-emitting regions 001 and the feedback signal line FBL in the second column of light-emitting regions 001 have substantially the same length. Although not illustrated in the figure, one end of the driving voltage signal line VLEDL in the first column of light-emitting regions 001 close to the first pad 107 is also substantially flush with one end of the driving voltage signal line VLEDL in the second column of light-emitting regions 001 close to the first pad 107, that is, the driving voltage signal line VLEDL in the first column of light-emitting regions 001 and the driving voltage signal line VLEDL in the second column of light-emitting regions 001 have substantially the same length. When the light-emitting substrate 200 comprises N columns of light-emitting regions 001, the same signal lines in respectively columns of light-emitting regions 001 have substantially the same length to maintain the uniformity of respectively columns of light-emitting regions 001. Here, "the same signal lines in respectively columns of light-emitting regions 001" refers to the signal lines with the same function in respectively columns of light-emitting regions 001, for example, the driving voltage signal lines VLEDL in the first column of light-emitting regions 001 to the N^{th} column of light-emitting regions 001 are the same signal lines. With such an arrangement, the same signal lines in respectively columns of light-emitting regions 001 can have substantially the same length, so the signal lines in respectively columns of light-emitting regions 001 have substantially the same resistance and voltage drop, so that, each column of light-emitting regions 001 has better luminance uniformity.

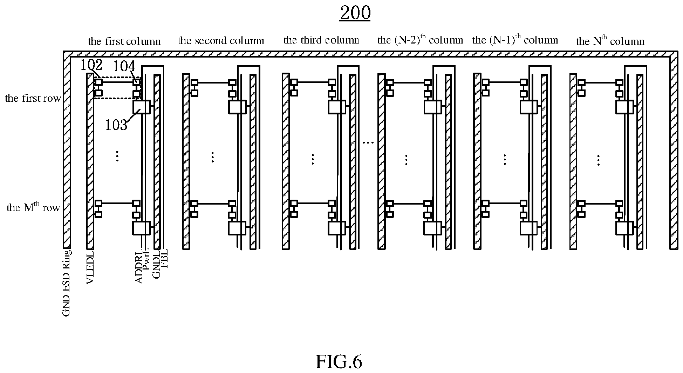

The light-emitting substrate 200 may further comprise a shielding ring GND ESD Ring, and FIG. 6 illustrates the shielding ring GND ESD Ring. The shielding ring GND ESD Ring surrounds the periphery of the plurality of light-emitting regions 102 to provide electrostatic shielding. The electrical signal received by the shielding ring GND ESD Ring is the same as that received by the common voltage signal line GNDL. For example, both the shielding ring GND ESD Ring and the common voltage signal line GNDL are connected to the bonding electrode of the bonding area, and the bonding electrode connecting the shielding ring GND ESD Ring has the same definition as the bonding electrode connecting the common voltage signal line GNDL. Therefore, the electrical signal received by the shielding ring GND ESD Ring is the same as the electrical signal received by the common voltage signal line GNDL. The shielding ring GND ESD Ring may be located on the same layer as the first electrically conductive portion 105 and the second electrically conductive portion 106. The shape of the shielding ring GND ESD Ring is not limited to the shape illustrated in FIG. 6, and it may have any appropriate shape as long as it can provide electrostatic shielding effect on the light-emitting region 102. In an example, the width of the shielding ring GND ESD Ring is greater than or equal to 200 µm.

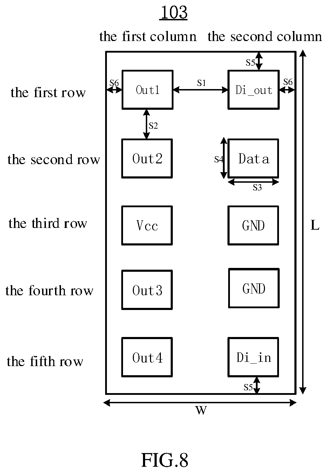

FIG. 7 illustrates the light-emitting substrate 300, and FIG. 8 illustrates the arrangement of terminals of the driving circuit 103 of the light-emitting substrate 300. The light-emitting substrate 300 illustrated in FIG. 7 has substantially the same configuration as the light-emitting substrate 200 illustrated in FIG. 2, and thus the same reference numerals are used to refer to the same components. Therefore, the detailed functions and functions of the components in FIG. 7 with the same reference numerals as those in FIG. 2 can be obtained by referring to the description of FIG. 2, which will not be repeated here. For the sake of brevity, different parts will be mainly discussed below.

Referring to FIGS. 7 and 8, different from the light-emitting substrate 200 in FIG. 2, the driving circuit 103 of the light-emitting substrate 300 in FIG. 7 has more terminals, wherein the number of output terminals Out is multiple, and the number of the common voltage terminals GND is at least one. FIG. 7 illustrates that the number of output terminals Out is four and the number of common voltage terminals GND is two, but this is just an example. The number of output terminals Out may be more or less than four, and the number of common voltage terminals GND may be more or less than two. In the embodiment of the present disclosure, the number of the output terminals Out is at least two, and the number of the common voltage terminal GND is at least one. In addition, the driving circuit 103 also comprises a data terminal Data. As illustrated in FIG. 7 and FIG. 8, the driving circuit 103 comprises two columns of terminals. The first column of terminals comprises a power terminal Vcc and four output terminals Out1, Out2, Out3, and Out4, and the first column of terminals is located on a side of the driving circuit 103 close to the driving voltage signal line VLEDL (i.e., on the left side of the driving circuit 103); the second column of terminals comprises an address terminal Di_in, a relay terminal Di_out, a data terminal Data and two common voltage terminals GND, and the second column of terminals is located on the side of the driving circuit 103 close to the common voltage signal line GNDL (i.e., on the right side of the driving circuit 103). The plurality of terminals of the driving circuit 103 are arranged in five rows, wherein the address terminal Di_in is located in the 5^{th} row of the plurality of terminals, and the relay terminal Di_out is located in the first row of the plurality of terminals. Although FIG. 8 illustrates that the power terminal Vcc is located in the third row of the first column of terminals, and the data terminal Data is located in the second row of the second column of terminals, this is only an example, and the embodiment of the present disclosure does not limit the specific position of the power terminal Vcc in the first column of terminals and the specific position of the data terminal Data in the second column of terminals. For example, the power terminal Vcc may be located in any one of the first row to the 5^{th} row of the first column of terminals, and the data terminal Data may be located in any one of the second row to the 4^{th} row of the second column of terminals.

As illustrated in the figure, the four output terminals Out1, Out2, Out3 and Out4 of the driving circuit 103 are connected to the second ends of the four light-emitting units 104 in a one-to-one correspondence to provide driving signals for the light-emitting units 104. In the example of FIG. 7, the output terminal and the relay terminal of the driving circuit 103 are different terminals. The driving circuit 103 is configured to, in one period, output a relay signal via the relay terminal Di_out as an address signal for the next-cascaded driving circuit 103 cascaded with the driving circuit 103, and in another period, respectively provide driving signals to the four light-emitting units 104 via the four output terminals Out1, Out2, Out3, and Out4. The one period and the another period are two separate periods, e.g. the another period immediately follows the one period. The driving signal may be, for example, a driving current for driving the light-emitting unit 104 to emit light. It should be noted that when the driving signal is a driving current, the driving current can flow from the output terminals Out1, Out2, Out3, and Out4 to the light-emitting units 104, or flow from the light-emitting units 104 to the output terminals Out1, Out2, Out3, and Out4, and the flow direction of the driving current may be determined according to actual requirements, which is not limited by the embodiments of the present disclosure.

Although FIG. 7 only illustrates four light-emitting regions 102 arranged in 2 rows*2 columns, this is only a part of the light-emitting substrate 300, and the light-emitting substrate 300 may comprise any appropriate number of light-emitting regions 102. The light-emitting regions 102 in any appropriate number can be arranged in M rows and N columns, and M and N can be any positive integers greater than or equal to 1. The embodiment of the present disclosure does not specifically limit the number of the light-emitting regions 102 comprised by the light-emitting substrate 300 .

As mentioned above, each column of light-emitting regions 001 comprises the driving voltage signal line VLEDL, the address selection signal line ADDRL, the cascade wiring 111, the power signal line VccL, the common voltage signal line GNDL, and the feedback signal line FBL extending along the first direction D1, and their orthographic projections on the substrate 101 do not overlap with each other. The functions and arrangement of these signal lines are as described above, and are not repeated here for the sake of brevity. Besides, each column of light-emitting regions 001 further comprises one data driving signal line DataL. Each data driving signal line DataL comprises a main portion and a second connection portion 119, and the main portion of the data driving signal line DataL extends along the first direction D1. In each column of light-emitting regions 001, one data driving signal line DataL is connected to the data terminals Data of all the driving circuits 103 in the column of light-emitting regions 001 via the second connection portion 119, and the orthographic projection of the first column of terminals of each driving circuit 103 on the substrate 101 and the orthographic projection of the second column of terminals of each driving circuit 103 on the substrate 101 are located on two sides of the orthographic projection of the data driving signal line DataL on the substrate 101, respectively. That is, the data driving signal line DataL is arranged within the area occupied by each driving circuit 103 and does not overlap with the first column of terminals and the second column of terminals of each driving circuit 103. The orthographic projection of the data driving signal line DataL on the substrate 101 also does not overlap with the orthographic projection of the power signal line VccL in the column of light-emitting regions 001 on the substrate 101. By arranging the data driving signal line DataL in each column of light emitting regions 001 to be in the area occupied by each driving circuit 103, wiring space can be saved and overlapping between the data driving signal line DataL and other signal lines can be avoided.

In each column of light-emitting regions 001, one data driving signal line DataL is configured to provide driving data to the data terminal Data of each driving circuit 103, and a plurality of different driving data can be loaded on the data driving signal line DataL, and each driving circuit 103 can determine the corresponding driving data according to its address information, and drive the light-emitting units 104 connected to the driving circuit 103 according to the corresponding driving data. In the embodiment of the present disclosure, the driving data is transmitted to the data terminal Data of the driving circuit 103 via the data driving signal line DataL, so the problem of too many pads and wires caused by using serial peripheral interface (SPI) for data transmission is avoided, and the structures of the light-emitting substrate 300, the external circuit and the driving circuit 103 can be simplified.

The spacing between the various terminals of the driving circuit 103 of the light-emitting substrate 300 is usually determined according to many factors (such as process limit capability, line width requirements between two columns of terminals, electrical design requirements, etc.), which is not specifically limited in the embodiment of the present disclosure. For example, the spacing between the first column of terminals and the second column of terminals may be 70-500µm, and the spacing between any two adjacent rows of terminals in the five rows of terminals may be 70-500um. As shown in FIG. 8, in an example, the spacing S1 between the first column of terminals and the second column of terminals is 210 µm, and the spacing S2 between the terminals in any two adjacent rows is 90 µm. That is, the spacing between the first output terminal Out1 and the relay terminal Di_out, the spacing between the second output terminal Out2 and the data terminal Data, the spacing between the power terminal Vcc and the common voltage terminal GND, the spacing between the third output terminal Out3 and the common voltage terminal GND, and the spacing between the fourth output terminal Out4 and the address terminal Di_in are S1, which is 210 µm; the spacing between the first output terminal Out1 and the second output terminal Out2, the spacing between the second output terminal Out2 and the power terminal Vcc, the spacing between the power terminal Vcc and the third output terminal Out3, the spacing between the third output terminal Out3 and the fourth output terminal Out4, the spacing between the relay terminal Di_out and the data terminal Data, the spacing between the data terminal Data and the common voltage terminal GND, the spacing between the common voltage terminal GND and the adjacent common voltage terminal GND, and the spacing between the common voltage terminal GND and the address terminal Di_in are S2, which is 90 µm. The ten terminals of the driving circuit 103 occupy substantially the same area, and have substantially the same length and width. The width S3 of each terminal along the second direction D2 is 110 µm, and the length S4 of each terminal along the first direction D1 is 100 µm. The spacing S5 between the 5^{th} row of terminals and the first side of the driving circuit 103 (i.e., the lower edge of the driving circuit 103) is 35 µm, that is, the spacing between the 4^{th} output terminal Out4 and the address terminal Di_in and the lower edge of the driving circuit 103 is 35 µm; the spacing S5 between the first row of terminals and the second side of the driving circuit 103 (i.e., the upper edge of the driving circuit 103) is 35 µm, that is, the spacing S5 between the first output terminal Out1 and the relay terminal Di_out and the upper edge of the driving circuit 103 is 35 µm. The spacing S6 between the first column of terminals and the third side of the driving circuit 103 (i.e. the left edge of the driving circuit 103) is 25 µm, and the spacing S6 between the second column of terminals and the fourth side of the driving circuit 103 (i.e., the right edge of the driving circuit 103) is 25 µm. Therefore, it can be known that the length L of the driving circuit 103 along the first direction D1 is 930 µm, and the width W of the driving circuit 103 along the second direction D2 is 480 µm. In each column of light-emitting regions 001, the spacing between the power signal line VccL and the first column of terminals and the second column of terminals may be 10-100 µm respectively, and the spacing between the data driving signal line DataL and the first column of terminals and the second column of terminals may be 10-100 µm respectively. In an example, the widths of the power signal line VccL and the data driving signal line DataL between the first column of terminals and the second column of terminals along the second direction D2 are both greater than or equal to 40 µm.

A driving circuit 103 illustrated in FIG. 7 comprises four output terminals, so one driving circuit 103 can be connected to four light-emitting units 104 at the same time, thereby greatly reducing the amount of the driving circuits 103 and the cost of the light-emitting substrate 300. Not only that, because the amount of the driving circuits 103 is reduced, the difficulty of manufacturing the light-emitting substrate 300 can be reduced, the influence of the bonding yield of the driving circuit 103 on the yield of the light-emitting substrate 300 can be reduced, and hence the yield of the light-emitting substrate 300 can be improved. In addition, the terminals of the driving circuit 103 are arranged as described above, so that in each column of the light-emitting regions 001, the orthographic projections of the driving voltage signal line VLEDL, the address selection signal line ADDRL, the cascade wiring 111, the power signal line VccL, the data driving signal line DataL, the common voltage signal line GNDL, and the feedback signal line FBL of the first electrically conductive portion 105 on the substrate 101 do not overlap with each other. In addition, the orthographic projections of the driving voltage signal line VLEDL, the common voltage signal line GNDL, and the feedback signal line FBL of the first electrically conductive portion 105 on the substrate 101 and the orthographic projections of the first pad 107 and the second pad 108 of the second electrically conductive portion 106 on the substrate 101 also do not overlap with each other. Therefore, short circuit or open circuit caused by overlapping of the first electrically conductive portion 105 and the second electrically conductive portion 106 can be completely avoided, thereby improving the light-emitting performance of the light-emitting substrate 300 and improving the light-emitting stability of the light-emitting substrate 300.

Hereinafter, the workflow of the light-emitting substrate 300 in FIG. 7 is briefly described.

When the driving circuit 103 starts to work, firstly, the power terminal Vcc of each driving circuit 103 in each column of light-emitting regions 001 is provided with a power voltage through the power signal line VccL to complete the initialization. In this way, the driving circuit 103 is powered on.

Next, the address writing operation is performed during the first period, that is, the ADDRL signal line inputs the address signal to the first-cascaded driving circuit 103 via the address terminal Di_in, thereby writing the address. In addition, the first-cascaded driving circuit 103 outputs a relay signal via the relay terminal Di_out, and the relay signal is transmitted to the address terminal Di_in of the second-cascaded driving circuit 103 via the cascade wiring 111 to be used as the address signal of the second-cascaded driving circuit 103. And so on, until all the driving circuits 103 complete the address information configuration.

Next, the driving configuration is performed during the second period. In each column of light-emitting regions 001, each data driving signal line DataL transmits the driving data signal to the data terminal Data of each driving circuit 103 for initialization configuration.

Then, during the third period, the driving voltage is supplied to the driving voltage signal line VLEDL, and at this time, the driving voltage transmitted on the driving voltage signal line VLEDL becomes a high level.

Next, during the fourth period, each driving circuit 103 generates the driving control signals corresponding to its output terminals in one-by-one according to the received driving data, and the driving control signal is used to control the current flowing through the corresponding output terminal. In this way, under the action of the driving voltage loaded on the driving voltage signal line VLEDL, the driving circuit 103 can control the current flowing through the light-emitting unit 104 to achieve the purpose of driving each connected light-emitting unit 104 according to the driving circuit 103.

Finally, during the fifth period, the system is turned off, that is, the driving circuit 103 is powered off, and the driving voltage provided by the driving voltage signal line VLEDL becomes a low level, and the light-emitting unit 104 stops emitting light.

The light-emitting substrate 300 illustrated in FIG. 7 can realize zone dimming. Each driving circuit 103 comprises four output terminals Out1, Out2, Out3, Out4. The driving circuit 103 further comprises a logic control module CTR and a control module CLM (not illustrated in the figure). The logic control module CTR comprises four modulation modules, namely a first modulation module PWMM1, a second modulation module PWMM2, a third modulation module PWMM3, and a fourth modulation module PWMM4. The first output terminal Out1 to the fourth output terminal Out4 are connected to the first modulation module PWMM1 to the fourth modulation module PWMM4 in a one-to-one correspondence. The control module CLM is configured to generate a first driving control signal, a second driving control signal, a third driving control signal, and a fourth driving control signal according to the driving data provided by the data driving signal line DataL, and respectively transmit them to the first modulation module PWMM1, the second modulation module PWMM2, the third modulation module PWMM3 and the fourth modulation module PWMM4. Taking the first output terminal Out1 as an example, the first modulation module PWMM1 is electrically connected to the first output terminal Out1, and can be turned on or off under the control of the first driving control signal, so that the first output terminal Out1 and the common voltage signal line GNDL are turned on or off. When the first modulation module PWMM1 is turned on, the common voltage signal line GNDL, the first output terminal Out1, the light-emitting unit 104 electrically connected to the first output terminal Out1, and the driving voltage signal line VLEDL form a signal loop, and the light-emitting unit 104 works; when the first modulation module PWMM1 is turned off, the above-mentioned signal loop is disconnected, and the light-emitting unit 104 does not work. In this way, the first modulation module PWMM1 can modulate the current flowing through the light-emitting unit 104 under the control of the first driving control signal, so that the current flowing through the light-emitting unit 104 presents a pulse width modulation signal. The first modulation module PWMM1 can modulate factors such as the duty cycle of the pulse width modulation signal flowing through the light-emitting unit 104 according to the first driving control signal, thereby controlling the working state of the light-emitting unit 104. When the light-emitting unit 104 comprises LEDs, by increasing the duty cycle of the pulse width modulation signal, the total light-emitting duration of the LEDs in one display frame can be increased, thereby increasing the total light-emitting brightness of the LEDs in the display frame, so that the brightness of the light-emitting substrate 300 in this area increases; on the contrary, by reducing the duty cycle of the pulse width modulation signal, the total light-emitting duration of the LEDs in one display frame can be reduced, thereby reducing the total light-emitting brightness of the LEDs in the display frame, thereby the brightness of the light-emitting substrate 300 in this area is reduced, so that the brightness of the light-emitting unit 104 electrically connected to the first output terminal Out1 is controllable. In a similar manner, the brightness of the light-emitting units 104 electrically connected to the second output terminal Out2, the third output terminal Out3, and the fourth output terminal Out4 can be controlled respectively, so as to control the brightness of each light-emitting unit 104 in the light-emitting substrate 300.

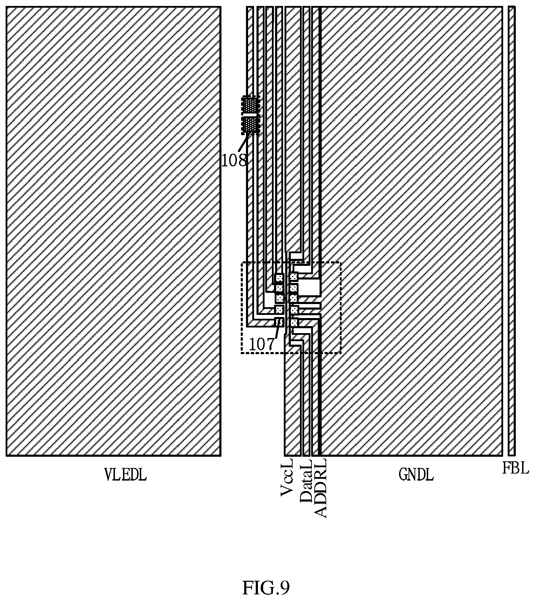

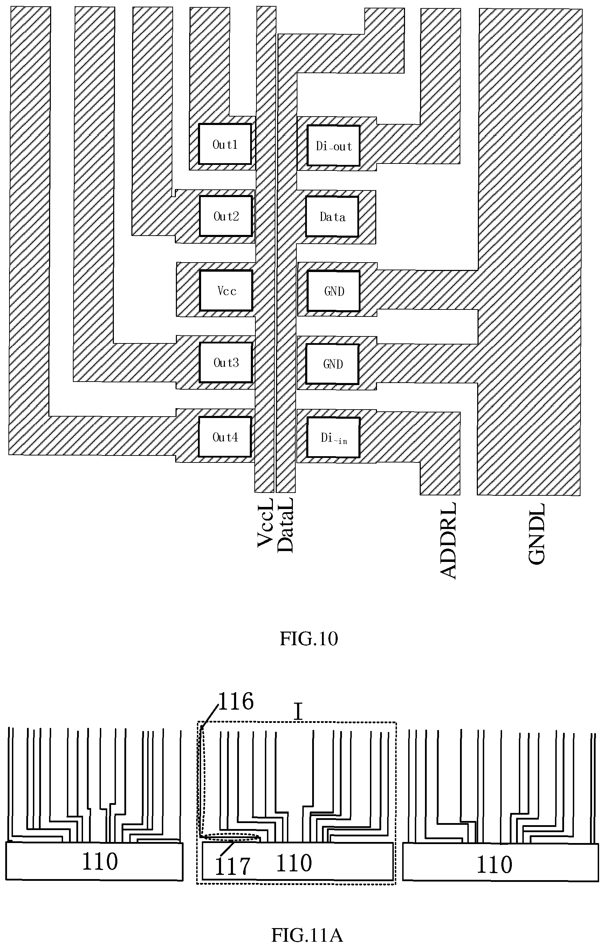

FIG. 9 illustrates a partial enlarged view of a column of light-emitting regions 001 of the light-emitting substrate 300 of FIG. 7, and FIG. 10 illustrates a further enlarged view of the structure within the dashed-line box in FIG. 9. As illustrated in FIGS. 9 and 10, the driving circuit 103 illustrated in FIG. 7 is mounted on the first pad 107, and the first pad 107 is electrically connected to the driving circuit 103. The second pad 108 comprises two sub-pads, for example, the two sub-pads are electrically connected to the anode and the cathode of the light-emitting unit 104, respectively. The first pad 107 is provided with ten sub-pads at positions respectively corresponding to the ten terminals of the driving circuit 103, which are respectively the first to fourth sub-pads for mounting and electrically connected to the four output terminals Out1 to Out4, a fifth sub-pad for mounting and electrically connected to the power terminal Vcc, a sixth sub-pad and a seventh sub-pad for mounting and respectively electrically connected to the two common voltage terminals GND, an eighth sub-pad for mounting and electrically connected to the address terminal Di_in, a ninth sub-pad for mounting and electrically connected to the relay terminal Di_out, and a tenth sub-pad for mounting and electrically connected to the data terminal Data. The fourth sub-pad is connected to the two sub-pads of the second pad 108 via wiring to transmit the driving signal to the light-emitting unit 104 electrically connected to the fourth terminal Out4. The fifth sub-pad is connected to the power signal line VccL to transmit the power voltage signal on the power signal line VccL to the power terminal Vcc. The sixth and seventh sub-pads are connected to the common voltage signal line GNDL to transmit the common voltage signal on the common voltage signal line GNDL to the two common voltage terminals GND. The eighth sub-pad is connected to the address selection signal line ADDRL to transmit the address signal on the address selection signal line ADDRL to the address terminal Di_in. The ninth sub-pad is connected to the cascade wiring, so as to output a relay signal during a period as an address signal of the next-cascaded driving circuit 103 cascaded with the driving circuit 103. The tenth sub-pad is connected to the data driving signal line DataL to transmit the data driving signal on the data driving signal line DataL to the data terminal Data.

In the light-emitting substrates provided by various embodiments of the present disclosure, such as the light-emitting substrate 100, the light-emitting substrate 200, and the light-emitting substrate 300, the spacing between each driving voltage signal line VLEDL and other adjacent signal lines needs to be greater than or equal to 0.2 mm. This is because the voltage on the driving voltage signal line VLEDL is relatively high (for example, about 10-50V), and the voltages of other signal lines adjacent to the driving voltage signal line VLEDL are usually relatively low. If the spacing is too small, it is easy to cause undesirable phenomena such as line breakdown. The spacing between other signal lines on the light-emitting substrate may be designed according to the process limit, which is not specifically limited in this embodiment of the present disclosure. For example, if the process limit is 20 µm, the spacing between other signal lines on the light-emitting substrate may be 20 µm.

Materials of the first electrically conductive portion 105 and the second electrically conductive portion 106 may be any appropriate electrically conductive material, which is not specifically limited in this embodiment of the present disclosure. For example, the material of the first electrically conductive portion 105 and the second electrically conductive portion 106 comprises copper. In an example, the first electrically conductive portion 105 and the second electrically conductive portion 106 may be a stack of Cu and CuNi. The side of the stack close to the substrate 101 is a Cu layer, the thickness of which may be, for example, 2 µm, and Cu is a preferred material as an electrical signal transmission channel. The side of the stack away from the substrate 101 is a CuNi layer, and its thickness may be, for example, 0.6 µm. The CuNi layer may be used to protect the Cu layer and prevent the surface of the Cu layer with low resistivity from being exposed and oxidized. In another example, the first electrically conductive portion 105 and the second electrically conductive portion 106 are, for example, a stack of MoNb/Cu/MoNb, and the side of the stack close to the substrate 101 is a MoNb layer with a thickness of about 300 Å, which is mainly used to improve the adhesion between the stack and the substrate 101; the intermediate layer of the stack is a Cu layer, and Cu is the preferred material for the electrical signal transmission channel; the side of the stack away from the substrate 101 is a MoNb layer with a thickness of about 200Å. The MoNb layer can be used to protect the intermediate Cu layer and prevent the surface of the intermediate Cu layer with low resistivity from being exposed and oxidized.

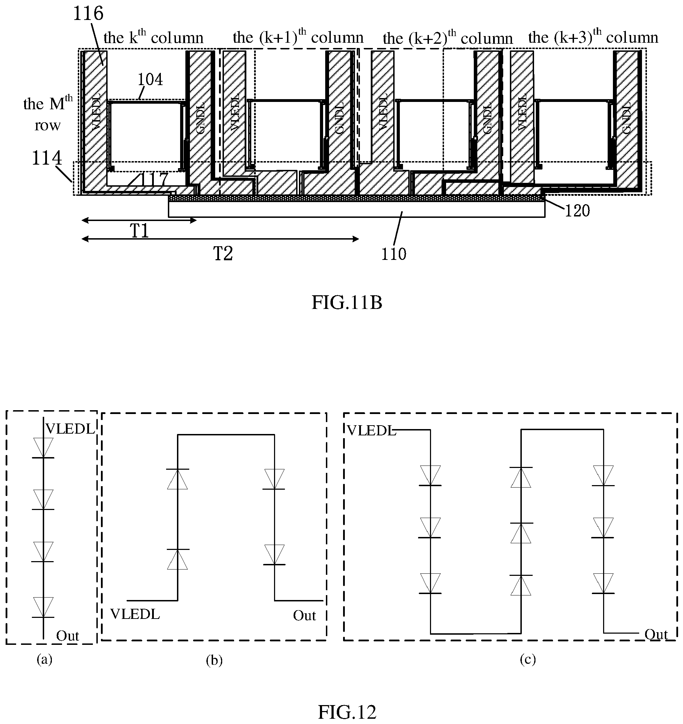

The light-emitting substrate described in any of the above embodiments may further comprise a plurality of flexible printed circuits 110. FIG. 11A illustrates the connection relationship between the plurality of flexible printed circuits 110 and the signal lines, and FIG. 11B illustrates a partial enlarged view of the area I in FIG. 11A, that is, a connection relationship between one flexible printed circuit 110 and the signal lines. As illustrated in FIGS. 11A and 11B, the flexible printed circuit 110 is disposed in the bonding area on the light-emitting substrate, and is electrically connected to the signal lines of the first electrically conductive portion 105 via the bonding electrodes 120 in the bonding area. In the example of FIG. 2, the flexible printed circuit 110 is electrically connected to the driving voltage signal line VLEDL, the address selection signal line ADDRL, the power signal line PwrL, the common voltage signal line GNDL, the feedback signal line FBL, and the shielding ring GND ESD Ring of the first electrically conductive portion 105, and the flexible printed circuit 110 provides the same signal for the common voltage signal line GNDL and the shielding ring GND ESD Ring. In the example of FIG. 7, the flexible printed circuit 110 is electrically connected to the driving voltage signal line VLEDL, the address selection signal line ADDRL, the power signal line VccL, the driving data signal line DataL, the common voltage signal line GNDL, the feedback signal line FBL, and the shielding ring GND ESD Ring of the first electrically conductive portion 105, and the flexible printed circuit 110 provides the same signal for the common voltage signal line GNDL and the shielding ring GND ESD Ring. FIG. 11B only illustrates the last row of light-emitting regions, that is, the M^{th} row of light-emitting regions, which shows four columns of light-emitting regions, i.e., the k^{th} column of light-emitting regions, the (k+1)^{th} column of light-emitting regions, the (k+2)^{th} column of light-emitting regions, and the (k+3)^{th} column of light-emitting regions, and the areas occupied by each column of light-emitting regions are respectively shown with dotted boxes. The four columns of light-emitting regions may be any adjacent four columns of light-emitting regions in the N columns of light-emitting regions. Each column of light-emitting regions comprises light-emitting units 104. Each signal line (for the sake of brevity, only the driving voltage signal line VLEDL and the common voltage signal line GNDL are marked in the figure) comprises a straight portion 116 extending along the first direction D1 and a bent portion 117, and the bent portion 117 is located within the fan-out area 114, each signal line is connected to the bonding electrode 120 via its bent portion 117, and the bonding electrode 120 is connected to the flexible printed circuit 110, thereby realizing the electrical connection between each signal line and the flexible printed circuit 110. The width of the bent portion 117 of each signal line along the second direction D2 is smaller than the width of two adjacent columns of light-emitting regions along the second direction D2. Taking the k^{th} column of light-emitting regions in FIG. 11 as an example, the width T1 of the bent portion 117 of the driving voltage signal line VLEDL along the second direction D2 is smaller than the width T2 of two adjacent columns (e.g., the k^{th} column and the (k+1)^{th} column) of light-emitting regions along the second direction D2. In the fan-out area 114, the angle between the straight portion 116 and the bent portion 117 of each signal line is 80°~100°. In an example, the angle between the straight portion 116 and the bent portion 117 of each signal line is 90°. In the related art, each flexible printed circuit corresponds to 5-15 columns of light-emitting regions, that is, each flexible printed circuit is electrically connected to the signal lines in 5-15 columns of light-emitting regions. In the present application, by increasing the number of flexible printed circuits 110, each flexible printed circuit corresponds to 3-8 columns of light-emitting regions 001, that is, each flexible printed circuit 110 is electrically connected to the signal lines in 3-8 columns of light-emitting regions 001. For example, in the example of FIG. 11B, each flexible printed circuit 110 is electrically connected to the signal lines in 4 columns of light-emitting regions 001. By increasing the number of the flexible printed circuits 110 and cooperating with the nearly right-angle bending design of the signal lines, each signal line can be extended to the bonding area in a substantially linear manner and connected with the flexible printed circuit 110. Compared with the related art, the fan-out area 114 of the light-emitting substrate provided by the embodiment of the present disclosure has a narrower width, so that the width of the lower frame of the light-emitting substrate can be reduced, which is beneficial to realize a narrow frame.

FIG. 12 illustrates several alternative arrangements of each light-emitting unit 104 as an example. Each light-emitting unit 104 comprises a plurality of light-emitting elements connected to each other, first ends of the plurality of light-emitting elements are electrically connected to the driving voltage signal line VLEDL, and second ends of the plurality of light-emitting elements are electrically connected to the output terminals Out of the driving circuit 103. FIG. 12(a) illustrates that each light-emitting unit 104 comprises four light-emitting elements connected in series with each other, and the four light-emitting elements are arranged in 1 column*4 rows; FIG. 12(b) illustrates that each light-emitting unit 104 comprises four light-emitting elements connected in series with each other, the four light-emitting elements are arranged in 2 columns*2 rows; FIG. 12(c) illustrates that each light-emitting unit 104 comprises nine light-emitting elements connected in series with each other, and the nine light-emitting elements are arranged in 3 columns*3 rows. Of course, the plurality of light-emitting elements in each light-emitting unit 104 are not limited to the above arrangement, and they may be arranged in any suitable manner. In an example, the plurality of light-emitting elements in each light-emitting unit 104 may be connected in parallel with each other. In another example, the plurality of light-emitting elements in each light-emitting unit 104 may be combined in series and in parallel. The number of light-emitting elements comprised in each light-emitting unit 104 may be determined according to actual requirements, for example, according to the size of the light-emitting substrate and the required brightness. Each light-emitting element may be an organic light-emitting diode or an inorganic light-emitting diode. In some embodiments, each light-emitting element may be a sub-millimeter light-emitting diode (Mini LED) or a micro light-emitting diode (Mirco LED). The size of the sub-millimeter light emitting diode is, for example, in the range of 100 micrometers to 500 micrometers; the size of the micro light-emitting diode is, for example, less than 100 micrometers. The embodiments of the present disclosure do not limit the types and sizes of light-emitting elements of the light-emitting unit 104. Using sub-millimeter light-emitting diodes or micro light-emitting diodes as light-emitting elements of the light-emitting unit 104, and combining the brightness of each light-emitting unit 104 with independent controllability, a high dynamic range (HDR) display can be realized. When such a light-emitting substrate is used in a display device, the contrast of the display device can be significantly improved.

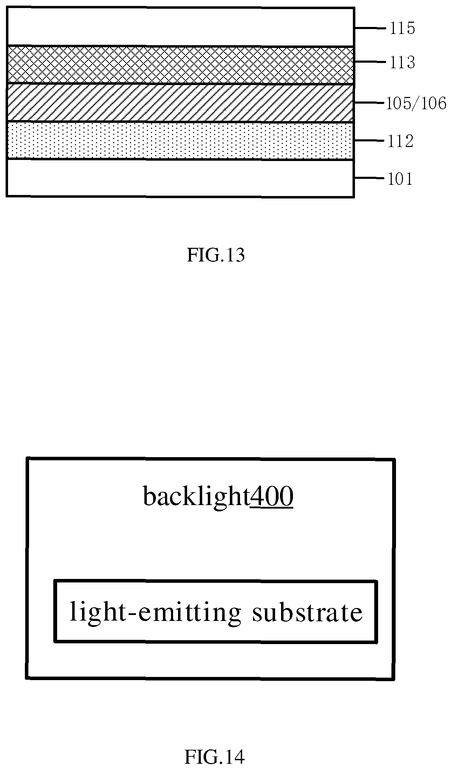

As illustrated in FIG. 13, the light-emitting substrate provided by various embodiments of the present disclosure may further comprise a buffer layer 112 and a first insulating layer 113. The buffer layer 112 is located between the layer where the first electrically conductive portion 105 and the second electrically conductive portion 106 are located and the substrate 101, and the first insulating layer 113 is located on the side of the layer where the first electrically conductive portion 105 and the second electrically conductive portion 106 are located away from the substrate 101. The buffer layer 112 can be used to reduce the stress caused to the substrate 101 when the first electrically conductive portion 105 and the second electrically conductive portion 106 are prepared, so as to avoid the bending deformation of the substrate 101; the buffer layer 112 can also avoid the adverse effects of impurities in the substrate 101 on the electrically conductive properties of the first electrically conductive portion 105 and the second electrically conductive portion 106. The buffer layer 112 may be any suitable material, for example, may be SiN. The first insulating layer 113 can be used to protect the first electrically conductive portion 105 and the second electrically conductive portion 106 from being oxidatively corroded by water, oxygen, etc. in the environment. The material of the first insulating layer 113 may be an organic material, an inorganic material, or a combination of an organic material and an inorganic material, and the first insulating layer 113 may be a single layer, or may comprise multiple layers. The substrate 101 may be any suitable substrate such as a plastic substrate, a silicon substrate, a ceramic substrate, a glass substrate, a quartz substrate, etc. The embodiment of the present disclosure does not limit the material of the substrate 101. Optionally, the light-emitting substrate may further comprise a second insulating layer 115, and the second insulating layer 115 is located on a side of the first insulating layer 113 away from the substrate 101. The material of the second insulating layer 115 may be an organic material, an inorganic material, or a combination of an organic material and an inorganic material, and the second insulating layer 115 may be a single layer, or may comprise multiple layers.

According to another aspect of the present disclosure, a backlight is provided, and FIG. 14 illustrates a block diagram of a backlight 400 comprising the light-emitting substrate described in any of the foregoing embodiments. The backlight 400 can be used as a backlight in a display device to provide a display light for a display panel in the display device. Of course, the backlight 400 may also be used in any other device that requires a light source, and the embodiments of the present disclosure do not specifically limit the use of the backlight 400.

Since the backlight 400 can have substantially the same technical effects as the light-emitting substrates described in the previous embodiments, for the sake of brevity, the technical effects of the backlight 400 will not be described again here.

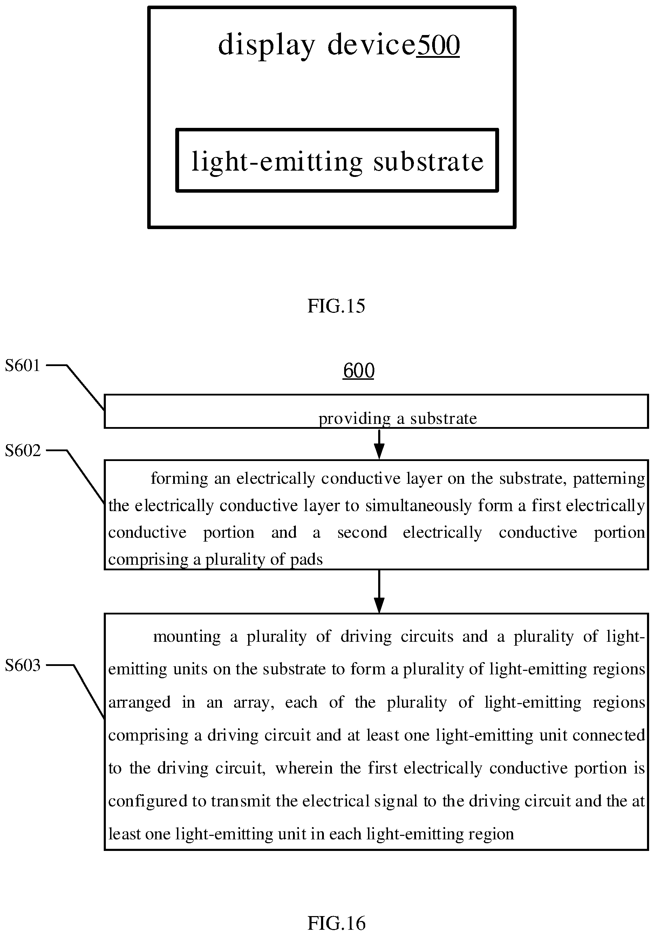

According to still another aspect of the present disclosure, a display device is provided, and FIG. 15 illustrates a block diagram of a display device 500 comprising the light-emitting substrate described in any of the foregoing embodiments. In some embodiments, the display device 500 may be a liquid crystal display device, which comprises a liquid crystal panel and a backlight disposed on a non-display side of the liquid crystal panel, the backlight comprising the light-emitting substrate described in any of the previous embodiments, which, for example, can be used to implement HDR dimming for display operation. The liquid crystal display device can have more uniform backlight brightness and better display contrast. The display device 500 can be any suitable display device, comprising but not limited to any product or component with display function, such as a mobile phone, a tablet computer, a television, a monitor, a notebook computer, a digital photo frame, a navigator, an e-book, and the like.

Since the display device 500 may have substantially the same technical effects as the light-emitting substrates described in the previous embodiments, for the sake of brevity, the description of the technical effects of the display device 500 will not be repeated here.

According to yet another aspect of the present disclosure, a method of manufacturing a light-emitting substrate is provided, and FIG. 16 illustrates a flowchart of the method 600, which is applicable to the light-emitting substrate described in any one of the foregoing embodiments. Referring to FIGS. 2, 7 and 16, the method 600 may comprise the following steps:
S601: providing a substrate 101.
S602: forming an electrically conductive layer on the substrate 101, and patterning the electrically conductive layer to simultaneously form a first electrically conductive portion 105 and a second electrically conductive portion 106 comprising a plurality of pads 107 and 108.
S603: mounting a plurality of driving circuits 103 and a plurality of light-emitting units 104 on the substrate 101 to form a plurality of light-emitting regions 102 arranged in an array, each light-emitting region 102 comprising a driving circuit 103 and at least one light-emitting unit 104 connected to the driving circuit 103. The first electrically conductive portion 105 is configured to transmit electrical signals to the driving circuit 103 and at least one light-emitting unit 104 in each light-emitting region 102.

The steps of the method 600 are described in more detail below with a specific example.

First, the substrate 101 is provided. The substrate 101 may be any suitable substrate such as a plastic substrate, a silicon substrate, a ceramic substrate, a glass substrate, a quartz substrate, etc. The embodiment of the present disclosure does not limit the material of the substrate 101.

Then, a buffer layer 112 is formed on the substrate 101 by, for example, a magnetron sputtering method. The buffer layer 112 can be used to reduce the stress caused to the substrate 101 when the first electrically conductive portion 105 and the second electrically conductive portion 106 are subsequently prepared, so as to avoid the bending deformation of the substrate 101; the buffer layer 112 can also avoid the adverse effects of impurities in the substrate 101 on the electrically conductive properties of the first electrically conductive portion 105 and the second electrically conductive portion 106 formed subsequently. The buffer layer 112 may be any suitable material, for example, may be SiN.

Next, an electrically conductive layer is formed on the substrate 101 by a magnetron sputtering method or an electroplating method, and the first electrically conductive portion 105 and the second electrically conductive portion 106 are simultaneously formed by patterning the electrically conductive layer. The first electrically conductive portion 105 may comprise the above-mentioned driving voltage signal line VLEDL, address selection signal line ADDRL, cascade wiring 111, power signal line VccL, data driving signal line DataL, common voltage signal line GNDL, feedback signal line FBL, and optional shield ring GND ESD Ring. The second electrically conductive portion 106 comprises a first pad 107 and a second pad 108. The first pad 107 is used for mounting the driving circuit 103, and the second pad 108 is used for mounting the light-emitting unit 104. Since the thickness of a single magnetron sputtering generally does not exceed 1 µm, when an electrically conductive layer exceeding 1 µm is produced, multiple times of sputtering are usually required to form the electrically conductive layer. In an example, the formation process of the first electrically conductive portion 105 and the second electrically conductive portion 106 can be expressed as follows: firstly, forming a Cu layer with a thickness of, for example, 2 µm on the buffer layer 112 to transmit various electrical signals; then, forming a CuNi layer with a thickness of, for example, 0.6 µm on the Cu layer, and the CuNi layer can be used to protect the Cu layer and prevent the surface of the Cu layer with low resistivity from being exposed and oxidized. In another example, the formation process of the first electrically conductive portion 105 and the second electrically conductive portion 106 can be expressed as follows: firstly, forming a MoNb layer with a thickness of about 300 Å on the buffer layer 112, and the MoNb layer is used to improve the adhesion between the layer and the substrate 101; then forming a Cu layer on the MoNb layer to transmit various electrical signals; finally, forming a MoNb layer with a thickness of about 200 Å on the Cu layer, in order to protect the intermediate Cu layer and prevent the surface of the intermediate Cu layer with low resistivity from being exposed and oxidized. When the first electrically conductive portion 105 and the second electrically conductive portion 106 are formed on the substrate 101 by an electroplating method, MoNiTi can be used to form a seed layer first, so as to improve the nucleation density of metal grains in the subsequent electroplating process. After that, a Cu layer with low resistivity is made by electroplating, and then an anti-oxidation layer is made, and the material can be MoNiTi. The electrically conductive layer may be subjected to processes such as cleaning, coating, baking, photolithography, developing, hard baking, etching, and stripping to form the first electrically conductive portion 105 and the second electrically conductive portion 106. Only two masks are needed to prepare the first electrically conductive portion 105 and the second electrically conductive portion 106 located on the same layer. Compared with the related art, in which at least three masks are required to form the electrically conductive structures in different layers, the number of masks can be reduced, the manufacturing process can be simplified, and the production cost can be reduced.

Then, a first insulating layer 113 is formed on the side of the layer where the first electrically conductive portion 105 and the second electrically conductive portion 106 are located away from the substrate 101 by a magnetron sputtering method. The first insulating layer 113 can be used to protect the first electrically conductive portion 105 and the second electrically conductive portion 106 from being oxidatively corroded by water, oxygen, etc. in the environment. The material of the first insulating layer 113 may be an organic material, an inorganic material, or a combination of an organic material and an inorganic material, and the first insulating layer 113 may be a single layer, or may comprise multiple layers.

Optionally, a second insulating film can also be coated on the side of the first insulating layer 113 away from the substrate 101, and the second insulating layer 115 is formed by performing several processes, such as curing, exposing, developing, and etching, on the second insulating film. The material of the second insulating layer 115 may be an organic material, an inorganic material, or a combination of an organic material and an inorganic material, and the second insulating layer 115 may be a single layer, or may comprise multiple layers. When the second insulating layer 115 is formed on the light-emitting substrate, the second insulating layer 115 and the first insulating layer 113 are etched to form a plurality of vias.

Finally, the light-emitting substrate is cut into a predetermined shape, and the driving circuits 103 and the light-emitting units 104 are electrically connected to the first pads 107 and the second pads 108 of the second electrically conductive portion 103 via the above-mentioned plurality of vias, respectively, so as to install the driving circuits 103 and the light-emitting units 104 on the corresponding pads. Each signal line of the first electrically conductive portion 105 is connected to the flexible printed circuit 110 at the bonding area, so as to realize the electrical connection between the driving circuit 103 and the flexible printed circuit 110, and finally obtain the desired light-emitting substrate.

For the technical effect achieved by the method 600, reference may be made to the technical effect of the light-emitting substrate described in the previous embodiments. Therefore, for the sake of brevity, the technical effect of the method 600 is not repeated here.

In the description of the present disclosure, the orientation or positional relationship indicated by the terms "upper", "lower", "left", "right", etc. is based on the orientation or positional relationship illustrated in the drawings. It is only for the convenience of describing the present disclosure and does not require that the present disclosure must be constructed and operated in a particular orientation, and therefore should not be construed as a limitation of the present disclosure.

In the description of this specification, description with reference to the terms "one embodiment," "another embodiment," etc. means that a particular feature, structure, material, or characteristic described in connection with the embodiment is comprised in at least one embodiment of the present disclosure. In this specification, schematic representations of the above terms are not necessarily directed to the same embodiment or example. Furthermore, the particular feature, structure, material or characteristic described may be combined in any suitable manner in any one or more embodiments or examples. Furthermore, those skilled in the art may combine the different embodiments or examples as well as the features of the different embodiments or examples described in this specification, without conflicting each other. In addition, it should be noted that in this specification, the terms "first" and "second" are only used for description purposes, and cannot be understood as indicating or implying relative importance or implicitly indicating the number of indicated technical features.

As those skilled in the art will appreciate, although the various steps of the methods of the present disclosure are depicted in the figures in a particular order, this does not require or imply that the steps must be performed in that particular order, unless the context clearly dictates otherwise. Additionally or alternatively, multiple steps may be combined into one step for execution, and/or one step may be decomposed into multiple steps for execution. Furthermore, other method steps may be inserted between the steps. The inserted steps may represent improvements to the method described herein, or may be unrelated to the method. Additionally, a given step may not be fully completed before the next step begins.

The above descriptions are merely specific embodiments of the present disclosure, but the protection scope of the present disclosure is not limited thereto. Any person skilled in the art can easily think of changes or substitutions within the technical scope disclosed by the present disclosure, which should be comprised within the protection scope of the present disclosure. Therefore, the protection scope of the present disclosure should be based on the protection scope of the claims.

## Claims

1. A light-emitting substrate comprising:
a substrate comprising a plurality of light-emitting regions arranged in an array, each of the plurality of light-emitting regions comprising a driving circuit and at least one light-emitting unit connected to the driving circuit;
a first electrically conductive portion on the substrate and connected to the driving circuit and the at least one light-emitting unit in each light-emitting region; and
a second electrically conductive portion on the substrate and comprising a plurality of pads,
wherein the first electrically conductive portion and the second electrically conductive portion are on a same layer.

2. The light-emitting substrate according to claim 1, wherein the plurality of light-emitting regions are arranged in M rows along a first direction and N columns along a second direction intersecting with the first direction, and both M and N are positive integers greater than or equal to 1,
the first electrically conductive portion comprises N driving voltage signal lines and N common voltage signal lines extending along the first direction, each column of light-emitting regions comprises one driving voltage signal line and one common voltage signal line,
in each column of light-emitting regions, the driving voltage signal line is connected to a first end of each light-emitting unit in the column of light-emitting regions, and the common voltage signal line is connected to each driving circuit in the column of light-emitting regions,
in each column of light-emitting regions, the driving voltage signal line, the light-emitting unit, the driving circuit, and the common voltage signal line are sequentially arranged along the second direction.

3. The light-emitting substrate according to claim 2, wherein orthographic projections of the driving voltage signal line, the light-emitting unit, the driving circuit, and the common voltage signal line on the substrate do not overlap with each other.

4. The light-emitting substrate according to claim 2 or 3, wherein each driving circuit comprises a plurality of terminals arranged in an array, and the plurality of terminals are arranged in at least two columns along the second direction,
the plurality of terminals comprise at least one output terminal and at least one common voltage terminal, the at least one output terminal and the at least one common voltage terminal are in different columns of the plurality of terminals,
in each column of light-emitting regions, the at least one output terminal of each driving circuit is connected to a second end of the at least one light-emitting unit connected to the driving circuit in a one-to-one correspondence, and the at least one common voltage terminal of each driving circuit is connected to the common voltage signal line in the column of light-emitting regions.

5. The light-emitting substrate according to claim 4, wherein,
the plurality of terminals further comprise an address terminal, a relay terminal and a power terminal,
the driving circuits in each column of light-emitting regions are cascaded in sequence, the address terminal of the i^{th}-cascaded driving circuit is on a side of the i^{th}-cascaded driving circuit close to the (i-1)^{th}-cascaded driving circuit, the relay terminal of the i^{th}-cascaded driving circuit is on a side of the i^{th}-cascaded driving circuit close to the (i+1)^{th}-cascaded driving circuit, 1<i<M and i is a positive integer,
the address terminal is configured to receive an address signal, the relay terminal is configured to output a relay signal, and the power terminal is configured to receive a power voltage signal.

6. The light-emitting substrate according to claim 5, wherein an extending direction of the first electrically conductive portion is parallel to a cascade direction of the driving circuits.

7. The light-emitting substrate according to claim 5, wherein the plurality of terminals of the driving circuit are arranged in a first column and a second column along the second direction, in each column of light-emitting regions, the first column of terminals of the driving circuit is on a side of the driving circuit close to the driving voltage signal line, and the second column of terminals of the driving circuit is on a side of the driving circuit close to the common voltage signal line.

8. The light-emitting substrate according to claim 7, wherein the first electrically conductive portion further comprises N power signal lines, each column of light-emitting regions comprises one power signal line, each power signal line comprises a main portion and a first connection portion, and the main portion of the power signal line extends along the first direction,
in each column of light-emitting regions, the power signal line is connected to the power terminal of each driving circuit in the column of light-emitting regions via the first connection portion, and an orthographic projection of the first column of terminals on the substrate and an orthographic projection of the second column of terminals on the substrate are respectively on both sides of an orthographic projection of the power signal line on the substrate.

9. The light-emitting substrate according to claim 8, wherein the first electrically conductive portion further comprises N address selection signal lines extending along the first direction, each column of light-emitting regions comprises one address selection signal line, in each column of light-emitting regions, the address selection signal line is connected to the address terminal of the first-cascaded driving circuit.

10. The light-emitting substrate according to claim 9, wherein the first electrically conductive portion further comprises a cascade wiring extending along the first direction, the cascade wiring is between two adjacent cascaded driving circuits in each column of light-emitting regions, and the relay terminal of the i^{th}-cascaded driving circuit is connected to the address terminal of the (i+1)^{th}-cascaded driving circuit via the cascade wiring.

11. The light-emitting substrate according to claim 10, wherein the first electrically conductive portion further comprises N feedback signal lines extending along the first direction, each column of light-emitting regions comprises one feedback signal line, in each column of light-emitting regions, the feedback signal line is connected to the relay terminal of the last-cascaded driving circuit, and the feedback signal line is at least partially on a side of the common voltage signal line away from the driving circuit in the column of light-emitting regions.

12. The light-emitting substrate according to claim 11, wherein orthographic projections of the driving voltage signal line, the address selection signal line, the cascade wiring, the power signal line, the common voltage signal line, and the feedback signal line on the substrate do not overlap with each other.

13. The light-emitting substrate according to any one of claims 8-12, wherein the plurality of terminals of the driving circuit comprise the address terminal, the power terminal, the common voltage terminal, and the output terminal,
the first column of terminals comprises the output terminal and the address terminal, and the second column of terminals comprises the common voltage terminal and the power terminal.

14. The light-emitting substrate according to claim 13, wherein the output terminal and the relay terminal of the driving circuit are a same terminal, the driving circuit is configured to, output a relay signal as the address signal of a next-cascaded driving circuit cascaded with the driving circuit via the output terminal during a first period, and provide a driving signal to the at least one light-emitting unit connected to the driving circuit via the output terminal during a second period.

15. The light-emitting substrate according to any one of claims 8-12, wherein the plurality of terminals of the driving circuit further comprise a data terminal, and the data terminal and the power terminal are in different columns of the plurality of terminals.

16. The light-emitting substrate according to claim 15, wherein a number of the output terminals of the driving circuit is plural and a number of the common voltage terminal of the driving circuit is at least one,
the first column of terminals comprises the power terminal and the plurality of output terminals, and the second column of terminals comprises the address terminal, the relay terminal, the data terminal, and the at least one common voltage terminal.

17. The light-emitting substrate according to claim 16, wherein the first electrically conductive portion further comprises N data driving signal lines, each column of light-emitting regions comprises one data driving signal line, each data driving signal line comprises a main portion and a second connection portion, the main portion of the data driving signal line extends along the first direction,
in each column of light-emitting regions, the data driving signal line is connected to the data terminal of each driving circuit in the column of light-emitting regions via the second connection portion, and the orthographic projection of the first column of terminals on the substrate and the orthographic projection of the second column of terminals on the substrate are respectively on both sides of an orthographic projection of the data driving signal line on the substrate, and the orthographic projection of the data driving signal line on the substrate and the orthographic projection of the power signal line on the substrate do not overlap with each other.

18. The light-emitting substrate according to claim 16, wherein the plurality of output terminals of the driving circuit are connected to the second ends of the plurality of light-emitting units connected to the driving circuit in a one-to-one correspondence,
the driving circuit is configured to, output a relay signal as the address signal of a next-cascaded driving circuit cascaded with the driving circuit via the relay terminal during a first period, and provide driving signals respectively to the plurality of light-emitting units via the plurality of output terminals during a second period.

19. The light-emitting substrate according to any one of claims 2-18, wherein a spacing between the driving voltage signal line and another signal line adjacent to the driving voltage signal line is greater than or equal to 0.2 mm.

20. The light-emitting substrate according to any one of claims 2-19, further comprising a plurality of flexible printed circuits and a fan-out area,
wherein each signal line of the first electrically conductive portion comprises a straight portion and a bent portion, the bent portion of each signal line is within the fan-out area, and the signal lines are connected to the plurality of flexible printed circuits via the bent portions, and
wherein a width of the bent portion of each signal line along the second direction is smaller than a width of two adjacent columns of light-emitting regions along the second direction.

21. The light-emitting substrate according to claim 20, wherein an angle between the straight portion and the bent portion of each signal line is 80°~100°.

22. The light-emitting substrate according to any one of claims 1-21, wherein a material of the first electrically conductive portion and the second electrically conductive portion comprises copper.

23. The light-emitting substrate according to any one of claims 1-22, wherein each light-emitting unit comprises a plurality of light-emitting elements connected to each other, each of the plurality of light-emitting elements comprises a sub-millimeter light-emitting diode or a micro light-emitting diode.

24. The light-emitting substrate according to any one of claims 2-23, further comprising a shielding ring, wherein the shielding ring surrounds the periphery of the plurality of light-emitting regions, and an electrical signal received by the shielding ring and an electrical signal received by the common voltage signal line are the same.

25. The light-emitting substrate according to any one of claims 1-24, further comprising a buffer layer and an insulating layer, wherein,
the buffer layer is between a layer where the first electrically conductive portion and the second electrically conductive portion are located and the substrate, and
the insulating layer is on a side of the layer where the first electrically conductive portion and the second electrically conductive portion are located away from the substrate.

26. A backlight comprising the light-emitting substrate according to any one of claims 1-25.

27. A display device comprising the light-emitting substrate according to any one of claims 1-25.

28. A method of manufacturing a light-emitting substrate, comprising:
providing a substrate;
forming an electrically conductive layer on the substrate, patterning the electrically conductive layer to simultaneously form a first electrically conductive portion and a second electrically conductive portion comprising a plurality of pads; and
mounting a plurality of driving circuits and a plurality of light-emitting units on the substrate to form a plurality of light-emitting regions arranged in an array, each of the plurality of light-emitting regions comprising a driving circuit and at least one light-emitting unit connected to the driving circuit,
wherein the first electrically conductive portion is connected to the driving circuit and the at least one light-emitting unit in each light-emitting region.
